(19) Europäisches Patentamt / European Patent Office / Office européen des brevets

(11) **EP 3 896 519 A1**

(12) **EUROPEAN PATENT APPLICATION**

(43) Date of publication:
20.10.2021 Bulletin 2021/42

(51) Int Cl.:
*G03F 7/00* (2006.01)　　　*G03F 7/027* (2006.01)
*B33Y 70/00* (2020.01)

(21) Application number: 20211692.7

(22) Date of filing: 28.03.2019

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **28.03.2018 US 201862649130 P**
　　　　　**20.04.2018 US 201862660894 P**

(62) Document number(s) of the earlier application(s) in accordance with Art. 76 EPC:
**19776310.5 / 3 776 081**

(71) Applicants:
  • **Lund, Benjamin**
    **Dallas TX 75252 (US)**
  • **Huffstetler, Jesse**
    **Dallas TX 75252 (US)**
  • **Zamorano, Daniel**
    **Dallas TX 75252 (US)**
  • **Das, Sushanta**
    **Dallas TX 75252 (US)**
  • **Niermann, Crystal**
    **Dallas TX 75252 (US)**
  • **Lund, Caleb**
    **Dallas TX 75252 (US)**
  • **Nguyen, Amy**
    **Dallas TX 75252 (US)**
  • **Wu, Yili**
    **Dallas TX 75252 (US)**
  • **Voit, Walter**
    **Dallas TX 75252 (US)**

(72) Inventors:
  • **Lund, Benjamin**
    **Dallas TX 75252 (US)**
  • **Huffstetler, Jesse**
    **Dallas TX 75252 (US)**
  • **Zamorano, Daniel**
    **Dallas TX 75252 (US)**
  • **Das, Sushanta**
    **Dallas TX 75252 (US)**
  • **Niermann, Crystal**
    **Dallas TX 75252 (US)**
  • **Lund, Caleb**
    **Dallas TX 75252 (US)**
  • **Nguyen, Amy**
    **Dallas TX 75252 (US)**
  • **Wu, Yili**
    **Dallas TX 75252 (US)**
  • **Voit, Walter**
    **Dallas TX 75252 (US)**

(74) Representative: **Finnegan Europe LLP**
    **1 London Bridge**
    **London SE1 9BG (GB)**

Remarks:
This application was filed on 03-12-2020 as a divisional application to the application mentioned under INID code 62.

(54) **THIOL-ACRYLATE POLYMERS, METHODS OF SYNTHESIS THEREOF AND USE IN ADDITIVE MANUFACTURING TECHNOLOGIES**

(57) The present disclosure relates to thiol-acrylate photopolymerizable resin compositions. The resin compositions may be used for additive manufacturing. One embodiment of the invention includes a photopolymerizable resin for additive manufacturing in an oxygen environment, the resin comprising: a crosslinking component; at least one monomer and/or oligomer; and a chain transfer agent comprising at least one of a thiol, a secondary alcohol, and/or a tertiary amine, wherein the resin may be configured to react by exposure to light to form a cured material.

EP 3 896 519 A1

FIG 2.

**Description**

**CROSS-REFERENCE TO RELATED APPLICATIONS**

This application claims priority to U.S. Provisional Application No. 62/649,130, filed March 28, 2018, and U.S. Provisional Application No. 62/660,894, filed April 20, 2018, the contents of which are incorporated herein by reference.

**FIELD OF INVENTION**

This invention is related generally to the field of additive manufacturing, and more particularly to three-dimensional (3D) printing materials, methods, and articles made therefrom.

**BACKGROUND**

Additive manufacturing or 3D printing refers to the process of fabricating 3D objects by selectively depositing material layer-by-layer under computer control. One category of additive manufacturing processes is vat photopolymerization in which 3D objects are fabricated from liquid photopolymerizable resins by sequentially applying and selectively curing a liquid photopolymerizable resin using light, for example ultraviolet, visible or infrared radiation.

Stereolithography (SLA) and digital light processing (DLP) are examples of vat photopolymerization type additive manufacturing processes. Typically, systems for SLA or DLP include a resin vat, a light source and a build platform. In laser-based stereolithography (SLA), the light source is a laser beam that cures the resin voxel by voxel. Digital light processing (DLP) uses a projector light source (e.g., a LED light source) that casts light over the entire layer to cure it all at once. The light source may be above or below the resin vat.

Generally, SLA and DLA printing methods include first applying a layer of the liquid resin on the build platform. For example, the build platform may be lowered down into the resin vat to apply the layer of resin. The liquid resin layer is then selectively exposed to light from the light source to cure selected voxels within the resin layer. For example, the resin may be cured through a window in the bottom of the resin vat by a light source from below (i.e. "bottom up" printing) or cured by a light source above the resin vat (i.e. "top down" printing). Subsequent layers are produced by repeating these steps until the 3D object is formed.

Liquid photopolymerizable resins for 3D printing cure or harden when exposed to light. For example, liquid photo-curable thiol-ene and thiol-epoxy resins have been used in such applications. Thiol-ene resins polymerize by reaction between mercapto compounds (-SH, "thiol") with a C=C double bond, often from a (meth-) acrylate, vinyl, allyl or norbornene functional group, of the "ene" compound. For photo- initiated thiol-ene systems, the reaction follows a radical addition of thiyl-radical to an electron rich or electron poor double bond. The nature of the double bond may contribute to the speed of the reaction. The reaction steps of the radical-initiated, chain-transfer, step-growth thiol-ene polymerization may proceed as follows: a thiyl radical is formed through the abstraction of a hydrogen radical; the thiyl radical reacts with a double bond, cleaving it, and forms a radical intermediate of the $\beta$-carbon of the ene; this carbon radical then abstracts a proton radical from an adjacent thiol, through a chain transfer, reinitiating the reaction which propagates until all reactants are consumed or trapped. In the case of di- and polyfunctional thiols and enes, a polymer chain or polymer network is formed via radical step growth mechanisms. Thiol-ene polymerizations can react either by a radical transfer from a photoinitiator or by direct spontaneous trigger with UV-irradiation (nucleophilic Michael additions are also possible between un-stabilized thiols and reactive enes).

For example, thiol-ene photopolymerizable resins have been cast and cured into polymers that show high crosslinking uniformity and a narrow glass transition temperature (Roper et al. 2004). These thiol-ene resins typically contain a molar ratio between 1:1, *Id*., and 20:80 (Hoyel et al. 2009) of thiol to ene monomer components. Additionally, thiol-ene resins comprising specific ratios of 1:1 to 2:1 pentaerithrytol tetrakis (3-mercaptopropionate) to polyethylene glycol have been used in 3D printing methods (Gillner et al. 2015).

One problem that may be encountered with additive manufacturing of liquid photopolymerizable resins is oxygen inhibition. Typically, in systems for vat photopolymerization type additive manufacturing processes, the resin vat is open and exposed to ambient air during printing. This allows oxygen to dissolve and diffuse into the liquid resin. Oxygen molecules scavenge the radical species needed for curing. Therefore, oxygen has an inhibitory effect, slowing the curing rate and increasing manufacturing times. Incomplete curing due to oxygen inhibition produces 3D objects having highly tacky, undesirable surface characteristics. Further, in top down printing systems, the top surface of the resin, having the highest oxygen concentration, is also the interface where the next layer of resin is to be applied. Oxygen at this interface inhibits polymerization between polymer chains of adjacent resin layers, leading to poor adhesion between layers of the 3D printed object ("interlayer adhesion"). To reduce the negative effects of oxygen, a nitrogen blanket has been used to reduce oxygen diffusion into the exposed top surface of the resin; however, this technique is expensive and complicates manufacturing systems.

Another problem that may be encountered is that the shelf-life stability of polymerizable resins is limited, e.g., due to ambient thermal free-radical polymerization. To prevent undesired polymerization in storage, resin components are cooled or mixed with stabilizers, including sulfur, triallyl phosphates and the aluminum salt of N-nitrosophenylhydroxylamine. This can result in higher operating costs during manufacturing as well as potential contamination of polymerized product with such stabilizers.

Another problem that may be encountered is that some liquid polymerizable resins do not exhibit low viscosities. While adequate for some casting applications, these higher viscosity resins can result in slower print rates for 3D printing, thus limiting the production process.

Additionally, another problem that may be encountered is that the thiols used in resins exhibit undesirable odors. This creates a disadvantage when using resins with high thiol content because this limits the ability to use them for open air applications such as 3D printing. Furthermore, compositions made from thiol-ene resins containing high thiol content may retain these undesirable odors in the event of partial or incomplete photocuring. To mitigate the effects of thiol odor, "masking agents" or low odor thiols (i.e., higher molecular weight thiols) have been used (Roper et al. 2004). However, incorporation of such masking agents may be expensive in the manufacturing process and cause potential undesired contamination of the polymerized composition. Furthermore, low odor, high molecular weight thiols are also expensive.

Additionally, compositions produced from thiol-containing resins may have problems due to anisotropic effects that cause x-y axis spread. For 3D printing applications, this results fidelity loss and a lack well-defined edges of the printed article.

Another problem that may be encountered is that 3D objects fabricated by additive manufacturing of liquid photopolymerizable resins exhibit undesirable mechanical properties (e.g., tensile modulation and strength, elongation performance and/or impact strength).

There remains a need for improved three-dimensional (3D) printing resin materials to overcome any of the problems noted above.

## BRIEF DESCRIPTION OF DRAWINGS

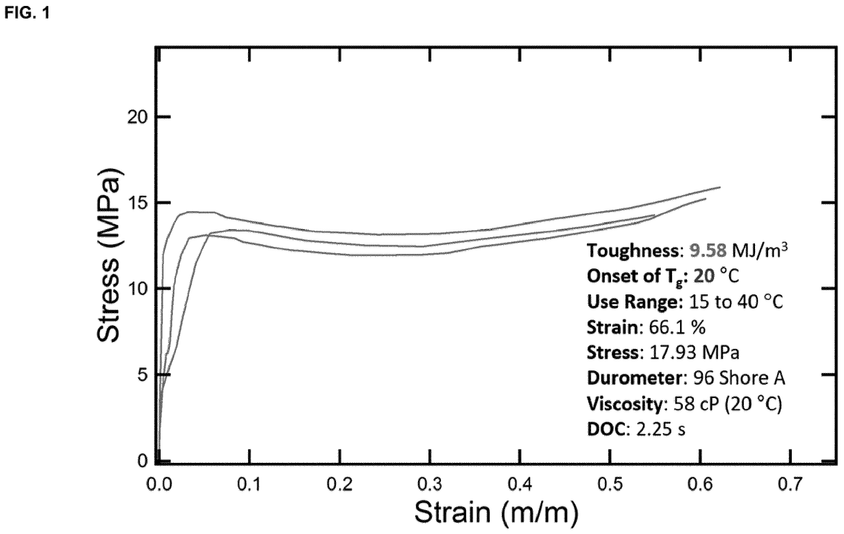

Figure 1 presents tensile stress versus strain behavior at 20°C for the thiol-acrylate resin consisting of the components shown in Table 1.

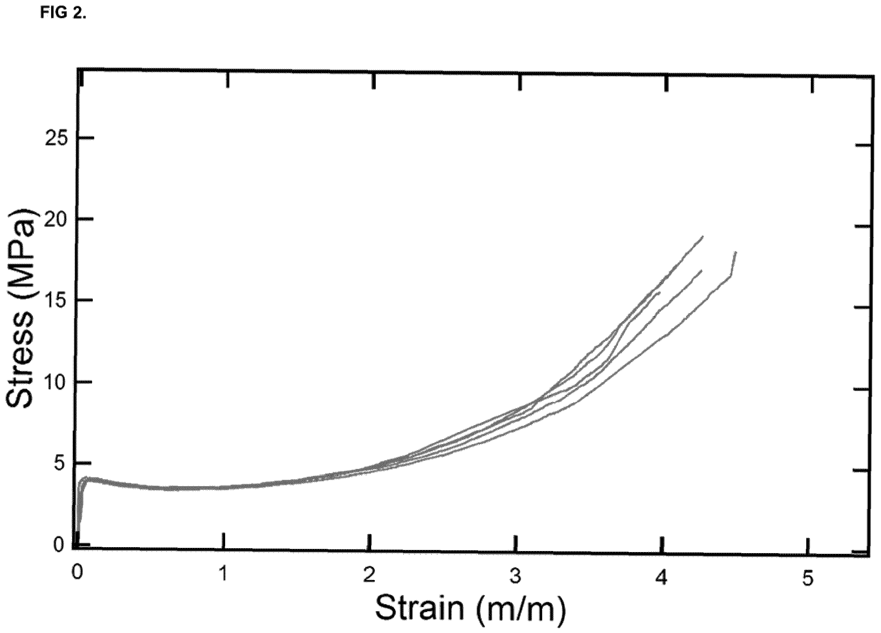

Figure 2 presents tensile stress versus strain behavior at 20°C for the thiol-acrylate resin consisting of the components shown in Table 2.

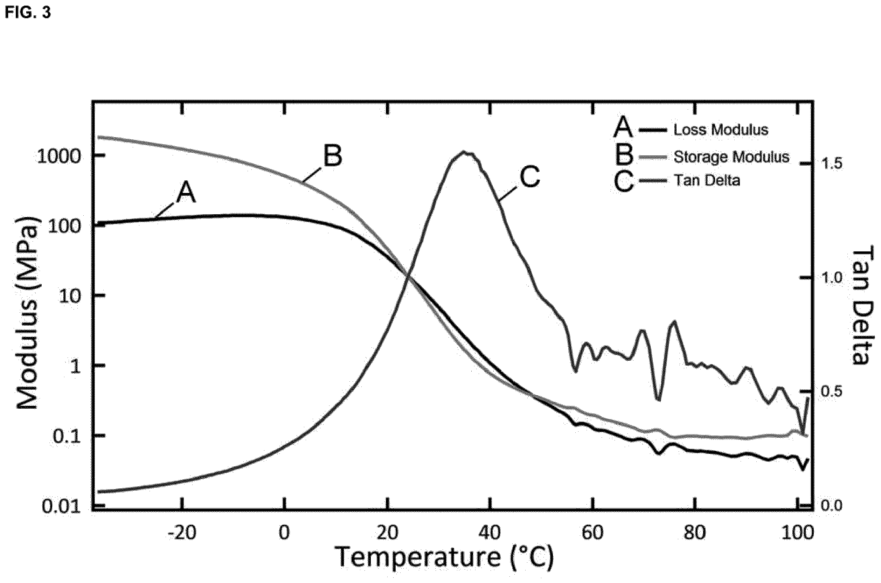

Figure 3 presents tan delta versus temperature profiles obtained from dynamic mechanical analysis for the thiol-acrylate resin consisting of the components shown in Table 2.

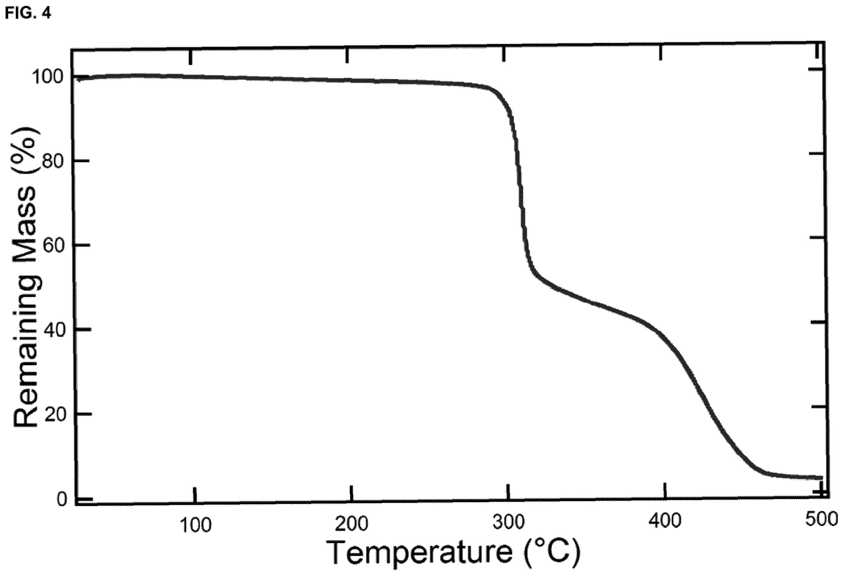

Figure 4 presents temperature and weight changes of decomposition reactions for the thiol-acrylate resin consisting of the components shown in Table 2.

## SUMMARY

The present disclosure relates to thiol-acrylate photopolymerizable resin compositions. The resin compositions may be used for additive manufacturing.

One embodiment of the invention includes a photopolymerizable resin for additive manufacturing in an oxygen environment, the resin comprising: a crosslinking component; at least one monomer and/or oligomer; and a chain transfer agent comprising at least one of a thiol, a secondary alcohol, and/or a tertiary amine, wherein the resin may be configured to react by exposure to light to form a cured material.

In some embodiments, the chain transfer agent is configured to permit at least some bonding between a layer of resin previously cured and an adjacent, subsequently cured layer of resin, despite an oxygen-rich surface present on the previously cured layer of resin at an interface between the previously cured layer of resin and the subsequently cured layer of resin.

In some embodiments, the invention includes a photopolymerizable resin for additive manufacturing printing in an oxygen environment, the resin comprising: a photoinitiator, wherein the photoinitiator is configured to generate a free radical after exposure to light; a crosslinking component; and at least one monomer and/or oligomer, wherein the crosslinking component and the at least one monomer and/or oligomer are configured to react with the free radical to provide growth of at least one polymer chain radical within a volume of the photopolymerizable resin, wherein the at least one polymer chain radical reacts with diffused oxygen to provide an oxygen radical; and a chain transfer agent comprising at least one of a thiol, a secondary alcohol, and/or a tertiary amine, wherein the chain transfer agent is configured to transfer the oxygen radical to initiate growth of at least one new polymer chain radical.

In some embodiments, the invention includes a photopolymerizable resin, the resin comprising: a crosslinking component; at least one monomer and/or oligomer, wherein the crosslinking component and the at least one monomer and/or oligomer are configured to react to provide one or more polymer chains after exposure to light; and a chain transfer agent comprising at least one of a thiol, a secondary alcohol, and/or a tertiary amine, wherein the chain transfer agent is configured to transfer a free radical associated with the one of the polymer chains to another one of the polymer chains.

In some embodiments, the invention includes a storage-stable photopolymerizable resin mixture, the resin mixture comprising: at least one monomer and/or oligomer, wherein the at least one monomer and/or oligomer includes one or more acrylic monomers, wherein the one or more acrylic monomers are at least about 50% by weight of the resin; and less than about 5% of a stabilized thiol comprising one or more thiol functional groups, wherein the stabilized thiol is configured to inhibit a nucleophilic substitution reaction between the one or more thiol functional groups and the one or more monomers or oligomers, wherein the components of the resin mixture can be combined and stored in a single pot for at least 6 months at room temperature with no more than 2%, 5%, 10%, 25%, 50% or 100% increase in the viscosity of the resin.

Another embodiment of the invention includes a photopolymerizable resin for additive manufacturing, the resin comprising: a crosslinking component; at least one monomer and/or oligomer; a photoinitiator, wherein the photoinitiator is configured to generate a free radical after exposure to light wherein the free radical initiates a chain reaction between the crosslinking component and the at least one monomer and/or oligomer to provide one or more polymer chains within a volume of the photopolymerizable resin; a chain transfer agent comprising at least one of a thiol, a secondary alcohol, and/or a tertiary amine, wherein the chain transfer agent is configured to reinitiate the chain reaction to provide one or more new polymer chains within a volume of the photopolymerizable resin, wherein a layer of the resin about 100 $\mu$m thick is configured to form a cured material in no more than 30 seconds; wherein the resin has a viscosity at room temperature of less than 1,000 centipoise.

Another embodiment of the invention includes a photopolymerizable resin for additive manufacturing, the resin comprising: less than 5% of a thiol; at least about 50% of one or more monomers; and a photoinitiator, wherein the photoinitiator is configured to form a free radical after exposure to light, such that the free radical initiates growth of one or more polymer chains including at least the difunctional and monofunctional monomers; wherein the thiol is configured to promote continued growth of the one or more polymer chains, wherein the resin is configured to react by exposure to light to form a cured material, wherein the cured material has a glass transition temperature in the range about 5-30°C.

Another embodiment of the invention includes a photopolymerizable resin for additive manufacturing, the resin comprising: less than about 5% of a thiol; and at least about 50% of one or more monomers; wherein the resin is configured to react to form a cured material; wherein the cured material has a toughness in the range about 3-30 MJ/m$^3$ and a strain at break ranging in the range about 30-300%.

Another embodiment of the invention includes a photopolymerizable resin for additive manufacturing, the resin comprising: less than about 5% of a thiol; and at least about 60% of one or more monomers, wherein the resin is configured to react by exposure to light to form a cured material; wherein the cured material has a toughness in the range about 3-100 MJ/m$^3$ and a strain at break in the range about 200-1000%.

Another embodiment of the invention includes a photopolymerizable resin for additive manufacturing, the resin comprising: at least at least one monomer and/or oligomer; and less than about 20% of a thiol, wherein the resin is configured to react by exposure to light to provide a cured material, wherein the cured material contains less than 1 part per 100 million of thiol volatiles at ambient temperature and pressure over 50 seconds in an oxygen environment.

Another embodiment of the invention includes a photopolymerizable resin for additive manufacturing, the resin comprising: about 5-15 phr of a thiol; about 20-60% of a difunctional acrylic oligomer; and about 40-80% of one or more monofunctional acrylic monomers; wherein the resin is configured to react by exposure to light to form a cured material.

Another embodiment of the invention includes a photopolymerizable resin for three-dimensional printing, the resin comprising: about 5-20 phr of a thiol; about 0-5 phr of polydimethylsiloxane acrylate copolymer; about 20-100% of a difunctional acrylic oligomer; and about 0-80% of at least one of a monofunctional acrylic monomer; wherein the resin is configured to react by exposure to light to form a cured material.

Another embodiment of the invention includes a photopolymerizable resin for three-dimensional printing, the resin comprising: about 5-10 phr of a thiol; about 0-20% of trimethylol propane triacrylate; about 30-50% of at least one of a difunctional acrylic oligomer; about 50-86% of isobornyl acrylate; and about 0-21% of hydroxypropyl acrylate; wherein the resin is configured to react by exposure to light to form a cured material.

Another embodiment of the invention includes a photopolymerizable resin adapted for three-dimensional printing, the resin comprising: about 4 to 6 phr of Pentaerythritol tetrakis (3-mercaptobutylate); about 40% to 50% of CN9167; and about 50% to 60% of hydroxypropyl acrylate; wherein the resin is configured to react by exposure to light to form a cured material.

Another embodiment of the invention includes a photopolymerizable resin for additive manufacturing, the resin comprising: less than about 5% of a thiol; at least about 50% of one or more acrylic monomers; and less than about 45% of one or more acrylic-functionalized oligomers, wherein the resin is configured to react by exposure to light to form a cured material; wherein the resin has a viscosity at room temperature of less than 1,000 cP; wherein the components of the resin can be combined and stored in a single pot for at least 6 months at room temperature with no more than 2%, 5%, 10%, 25%, 50% or 100% increase in the viscosity of the resin.

Another embodiment of the invention includes a photopolymerizable resin for additive manufacturing, the resin comprising: less than about 5% of a stabilized thiol; at least 50% of one or more acrylic monomers; and less than about 45% of one or more acrylic-functionalized oligomers, wherein the resin is configured to react by exposure to light to form a cured material; wherein the components of the resin can be combined and stored in a single pot for at least 6 months at room temperature with no more than 2%, 5%, 10%, 25%, 50% or 100% increase in the viscosity of the resin.

Another embodiment of the invention includes a photopolymerizable resin for three-dimensional printing, the resin comprising: about 4 to 6 phr of Pentaerythritol tetrakis (3-mercaptobutylate); about 0% to 5% of Trimethylolpropane triacrylate; about 25% to 35% of CN9004; and about 65% to 75% of Isobornyl acrylate; wherein the resin is configured to react by exposure to light to form a cured material.

Another embodiment of the invention includes a photopolymerizable resin for additive manufacturing, the resin comprising: about 4 to 6 phr of Pentaerythritol tetrakis (3-mercaptobutylate); about 20% to 40% of CN9004; and about 60% to 80% of hydroxypropyl acrylate; wherein the resin is configured to react by exposure to light to form a cured material.

Another embodiment of the invention includes a photopolymerizable resin for additive manufacturing comprising: less than about 5% of a stabilized thiol; and at least about 50% of one or more monomers; wherein the resin is configured to react by exposure to light to form a cured material, wherein a layer of the resin about 100 $\mu$m thick is configured to form a cured material in no more than 30 seconds; wherein the cured material has a toughness in the range about 3-100 MJ/m$^3$ and a strain at break in the range about 30-1000%.

Another embodiment of the invention includes a photopolymerizable resin for three-dimensional printing, the resin comprising: about 5-10 phr of a thiol; about 0-5% of trimethylolpropane triacrylate; about 30-50% of at least one of a difunctional acrylic oligomer; about 5-75% of isobornyl acrylate; and about 0-80% of hydroxypropyl acrylate; wherein the resin is configured to react by exposure to light to form a cured material.

Another aspect of the invention provides an article having a majority of layers comprising any of the photopolymerizable resins described in this disclosure.

## DETAILED DESCRIPTION

One embodiment of the invention includes a photopolymerizable resin for additive manufacturing in an oxygen environment, the resin comprising: a crosslinking component; at least one monomer and/or oligomer; and a chain transfer agent comprising at least one of a thiol, a secondary alcohol, and/or a tertiary amine, wherein the resin may be configured to react by exposure to light to form a cured material.

The crosslinking component may include any compound that reacts by forming chemical or physical links (e.g., ionic, covalent, or physical entanglement) between the resin components to form a connected polymer network. The crosslinking component may include two or more reactive groups capable of linking to other resin components. For example, the two or more reactive groups of the crosslinking component may be capable of chemically linking to other resin components. The crosslinking component may include terminal reactive groups and/or side chain reactive groups. The number and position of reactive groups may affect, for example, the crosslink density and structure of the polymer network.

The two or more reactive groups may include an acrylic functional group. For example, a methacylate, acrylate or acrylamide functional group. In some cases, the crosslinking component includes a difunctional acrylic oligomer. For example, the crosslinking component may include an aromatic urethane acrylate oligomer or an aliphatic urethane acrylate oligomer. The crosslinking component may include at least one of CN9167, CN9782, CN9004, poly(ethylene glycol) diacrylate, bisacrylamide, tricyclo[5.2.1.0$^{2,6}$]decanedimethanol diacrylate, and/or trimethylolpropane triacrylate. The size of the crosslinking component may affect, for example, the length of crosslinks of the polymer network.

The number of crosslinks or crosslink density may be selected to control the properties of the resulting polymer network. For example, polymer networks with fewer crosslinks may exhibit higher elongation, whereas polymer networks with greater crosslinks may exhibit higher rigidity. This may be because the polymer chains between the crosslinks may stretch under elongation. Low crosslink-density chains may coil up on themselves to pack more tightly and to satisfy entropic forces. When stretched, these chains can uncoil and elongate before pulling on crosslinks, which may break before they can elongate. In highly crosslinked materials, the high number of crosslinked chains may lead to little or no uncoilable chain length and nearly immediate bond breakage upon strain.

The amount of the crosslinking component may be selected to control the crosslink density and resulting properties of the polymer network. In some cases, the crosslinking component is 1-95% by weight of the resin. In other cases, the crosslinking component is >1%, 1.0-4.99%, 5-10% or about 20%, 30%, 40%, 50%, 60%, 70%, 80%, or 90% by weight of the resin.

In some cases, the resin includes at least one monomer and/or oligomer. In some embodiments, the at least one monomer and/or oligomer is 1-95% by weight of the resin. In other cases, the at least one monomer and/or oligomer is >1%, 1.0-4.99%, 5-10% or about 20%, 30%, 40%, 50%, 60%, 70%, 80%, or 90% by weight of the resin. The monomer may include small molecules that combine with each other to form an oligomer or polymer. The monomer may include bifunctional monomers having two functional groups per molecule and/or polyfunctional monomers having more than one functional group per molecule. The oligomer may include molecules consisting of a few monomer units. For example, in some cases, the oligomer may be composed of two, three, or four monomers (i.e., dimer, trimer, or tetramer). The oligomer may include bifunctional oligomers having two functional groups per molecule and/or polyfunctional oligomers having more than one functional group per molecule.

The at least one monomer and/or oligomer may be capable of reacting with the other resin components to form a connected polymer network. For example, the at least one monomer and/or oligomer may include one or more functional groups capable of reacting with the two or more reactive groups of the crosslinking component. The at least one monomer and/or oligomer may include an acrylic functional group. For example, a methacylate, acrylate or acrylamide functional group.

In some cases, at least one monomer and/or oligomer includes one or more monomers. For example, the one or more monomers may be about 1-95% by weight of the resin. Or, the resin may comprise at least about 50% or at least about 60% of one or more monomers. In other cases, at least one monomer and/or oligomer includes an acrylic monomer. The acrylic monomer may have a molecular weight less than 200 Da, less than 500 Da, or less than 1,000 Da. The acrylic monomer may include at least one of 2-ethylhexyl acrylate, hydroxypropyl acrylate, cyclic trimethylolpropane formal acrylate, isobornyl acrylate, butyl acrylate, and/or N,N'-Dimethylacrylamide.

Chain transfer agents may include any compound that possesses at least one weak chemical bond that potentially reacts with a free-radical site of a growing polymer chain and interrupts chain growth. In the process of free radical chain transfer, a radical may be temporarily transferred to the chain transfer agent which reinitiates growth by transferring the radical to another component of the resin, such as the growing polymer chain or a monomer. The chain transfer agent may affect kinetics and structure of the polymer network. For example, the chain transfer agent may delay formation of the network. This delayed network formation may reduce stress in the polymer network leading to favorable mechanical properties,

In some cases, the chain transfer agent may be configured to react with an oxygen radical to initiate growth of at least one new polymer chain and/or reinitiate growth of a polymer chain terminated by oxygen. For example, the chain transfer agent may include a weak chemical bond such that the radical may be displaced from the oxygen radical and transferred to another polymer, oligomer or monomer.

Additive manufacturing processes, such as 3D printing, may produce three dimensional objects by sequentially curing layers of a photopolymerizable resin. Thus, articles produced by additive manufacturing may comprise a majority or plurality of photocured layers. Additive manufacturing may be performed in an oxygen environment, wherein oxygen may diffuse into a deposited layer of resin.

In some cases, an oxygen radical may be formed by a reaction of diffused oxygen with a growing polymer chain. For example, at the oxygen-rich surface of a layer of resin, oxygen may react with initiator radicals or polymer radicals to form an oxygen radical. The oxygen radical may be affixed to a polymer side chain. Oxygen radicals, for example, peroxy radicals, may slow down curing of the resin. This slowed curing may lead, for example, to the formation of a thin, sticky layer of uncured monomers and/or oligomers at the oxygen-rich surface of a previously cured layer of resin, which would otherwise minimize adhesion to an adjacent subsequently cured layer of resin.

Due at least in part to the presence of a chain transfer agent, at least some bonding between a layer of resin previously cured and an adjacent, subsequently cured layer of resin, may occur despite an oxygen-rich surface present on the previously cured layer of resin at an interface between the previously cured layer of resin and the subsequently cured layer of resin. In some cases, the bonding may be covalent. In some embodiments, the bonding may be ionic. In some cases, the bonding may be physical entanglement of polymer chains. Additionally, in some cases, the chain transfer agent is ½-50% by weight of resin. In some cases, the chain transfer agent is about 0.5-4.0%, 4.0-4.7%, 4.7-4.99%, 4.99-5%, or 5-50% by weight of the resin.

The thiol-acrylate photopolymerizable resin materials may exhibit excellent interlayer strength when 3D printed in air environments. Because three-dimensional prints are built layer by layer, when printing in open-air, each resin layer will have an opportunity (e.g., during patterning) to become enriched with oxygen at its surface exposed to air. With prior resins, this oxygen enrichment resulted in weak adhesion between layers because the oxygen available at the oxygen-rich interfaces between layers inhibited free-radical polymerization, thereby limiting chain growth and retarding the reaction. The thiol-acrylate photopolymerizable resins, however, include a chain transfer agent (e.g., a secondary thiol) that may overcome this problem and promote the chemical and physical crosslinking between 3D printed layers even in the presence of elevated or ambient oxygen levels at the interfaces between layers.

Further, the thiol-acrylate photopolymerizable resin materials may demonstrate lower sensitivity to oxygen. In free-radical polymerization systems, oxygen reacts with primary initiating or propagating radicals to form peroxy radicals. In prior resins, these peroxy radicals would tend to terminate polymerization. In the thiol-acrylate photopolymerizable resins, however, thiols may act as a chain transfer agent allowing for further propagation of the polymerization reaction. Lower sensitivity to oxygen may enable open-air manufacturing processes without the expense of reduced-oxygen manufacturing (e.g., a nitrogen or argon blanket).

The thiol-acrylate photopolymerizable resin may undergo a chain transfer reaction during photocuring. Chain transfer is a reaction by which the free radical of a growing polymer chain may be transferred to a chain transfer agent. The newly formed radical then reinitiates chain growth. It is thought that the chain transfer reaction may reduce stress in materials formed from thiol-acrylate photopolymerizable resins, among other benefits.

In some cases, the chain transfer agent may be configured to transfer a radical from a first polymer chain or chain branch within the previously cured resin layer to a second polymer chain or chain branch within the volume of the photopolymerizable resin. This may, for example, enable formation of chemical or physical crosslinks between adjacent photocured layers in an article produced by additive manufacturing. In other cases, the chain transfer agent may be configured to promote growth of at least one new polymer chain near the oxygen-rich surface present on the previously cured layer of resin. This too may, for example, enable formation of chemical or physical crosslinks between adjacent photocured layers in an article produced by additive manufacturing. Further, the thiol-acrylate photopolymerizable resin may include a monomer or oligomer with a side chain able to cooperate with the chain transfer agent to affect the chain transfer mechanism.

The chain transfer agent may comprise at least one of a thiol, a secondary alcohol, and/or a tertiary amine. The secondary alcohol may include at least one of isopropyl alcohol, and/or hydroxypropyl acrylate. In some cases, the thiol is about 0.5% to 4.0%, 4.0% to 4.7%, 4.7% to 4.99%, 4.99-5%, or 5-50% by weight of the resin. The thiol may include a secondary thiol. The secondary thiol may include at least one of Pentaerythritol tetrakis (3-mercaptobutylate); 1,4-bis (3-mercaptobutylyloxy) butane; and/or 1,3,5-Tris(3-melcaptobutyloxethyl)-1,3,5-triazine. The tertiary amine may include at least one of aliphatic amines, aromatic amines, and/or reactive amines. The tertiary amine may include at least one of triethyl amine, N,N'-Dimethylaniline, and/or N,N'-Dimethylacrylamide.

Any suitable additive compounds may be optionally added to the resin. For example, the resin may further comprise poly(ethylene glycol). The resin may further comprise polybutadiene. The resin may further comprise polydimethylsiloxane acrylate. The resin may further comprise copolymer poly(styrene-co-maleic anhydride).

The resin may further comprise a photoinitiator, an inhibitor, a dye, and/or a filler. The photoinitiator may be any compound that undergoes a photoreaction on absorption of light, producing a reactive free radical. Therefore, photoinitiators may be capable of initiating or catalyzing chemical reactions, such as free radical polymerization. The photoinitiator may include at least one of Phenylbis(2,4,6-trimethylbenzoyl)phosphine oxide, Diphenyl(2,4,6-trimethylbenzoyl)phosphine oxide, Bis-acylphosphine oxide, Diphenyl(2,4,6-trimethylbenzoyl)phosphine oxide, and/or 2,2'-Dimethoxy-2-phenylacetophenone. In some cases, the photoinitiator is 0.01-3% by weight of the resin.

The inhibitor may be any compound that reacts with free radicals to give products that may not be able to induce further polymerization. The inhibitor may include at least one of Hydroquinone, 2-methoxyhydroquinone, Butylated hydroxytoluene, Diallyl Thiourea, and/or Diallyl Bisphenol A.

The dye may be any compound that changes the color or appearance of a resulting polymer. The dye may also serve to attenuate stray light within the printing region, reducing unwanted radical generation and overcure of the sample. The dye may include at least one of 2,5-Bis(5-tert-butyl-benzoxazol-2-yl)thiophene, Carbon Black, and/or Disperse Red 1.

The filler may be any compound added to a polymer formulation that may occupy the space of and/or replace other resin components. The filler may include at least one of titanium dioxide, silica, calcium carbonate, clay, aluminosilicates, crystalline molecules, crystalline oligomers, semi-crystalline oligomers, and/or polymers, wherein said polymers are between about 1,000 Da and about 20,000 Da molecular weight.

The resin viscosity may be any value that facilitates use in additive manufacturing (e.g., 3D printing) of an article. Higher viscosity resins are more resistant to flow, whereas lower viscosity resins are less resistant to flow. Resin viscosity may affect, for example, printability, print speed or print quality. For example, the 3D printer may be compatible only with resins having a certain viscosity. Or, increasing resin viscosity may increase the time required to smooth the surface of the deposited resin between print layers because the resin may not settle out as quickly.

The thiol-acrylate photopolymerizable resin of the disclosed materials may also possess a high cure rate and low viscosity. Additive manufactured objects are created by building up materials layer-by-layer. Each layer is built by depositing liquid resin and applying light to photocure. The viscosity and cure rate of the resin, therefore, affect print speed. A low viscosity resin will quickly spread (e.g., 1-30 seconds) into a flat layer, without the need to apply heat or mechanically manipulate the layer. The spread can be faster (e.g., 1 - 10 seconds) with mechanical manipulation. Additionally, lower viscosity may allow faster movement of the recoating blade. The faster the cure rate, the more quickly a next, subsequent layer can be built.

The resin viscosity may be tuned, for example, by adjusting the ratio of monomers to oligomers. For example, a resin having higher monomer content may exhibit a lower viscosity. This may be because the lower molecular weight monomers are able to solvate the oligomers, decreasing oligomer-oligomer interactions and thus decreasing the overall resin viscosity. The resin may have a viscosity at or above room temperature of less than about 250 centipoise, less than about 500 centipoise, less than about 750 centipoise, or less than about 1,000 centipoise. In some cases, the resin has a viscosity at a temperature between 0°C and 80°C of less than about 1000 centipoise, less than about 500 centipoise, or less than about 100 centipoise.

An article may be made from the resin as described in any embodiment. The article may be made by cast polymerization or additive manufacturing processes, such as 3D printing. The article may include footwear midsole, a shape memory foam, an implantable medical device, a wearable article, an automotive seat, a seal, a gasket, a damper, a hose, and/or a fitting. An article may be made having a majority of layers comprising the resin as described in any embodiment.

In some embodiments, an article may be made from the resin as described in any embodiment further includes a surface coating. The surface coating may be applied to an article for potentially obtaining desired appearance or physical properties of said article. The surface coating may comprise a thiol. The surface coating may comprise a secondary thiol. The surface coating may comprise an alkane. The surface coating may comprise a siloxane polymer. The surface coating may comprise at least one of semi-fluorinated poly ether and/or per-fluorinated poly ether.

In some embodiments, the photoinitiator may be configured to generate a free radical after exposure to light. In some embodiments, the crosslinking component and the at least one monomer and/or oligomer are configured to react with the free radical to provide growth of at least one polymer chain radical within a volume of the photopolymerizable resin. In some embodiments, the at least one polymer chain radical reacts with diffused oxygen to provide an oxygen radical. In some embodiments, the chain transfer agent may be configured to transfer the oxygen radical to initiate growth of at least one new polymer chain radical.

In some embodiments, the crosslinking component and the at least one monomer and/or oligomer are configured to react to provide one or more polymer chains after exposure to light. In some embodiments, the chain transfer agent may be configured to transfer a free radical associated with the one of the polymer chains to another one of the polymer chains.

In some embodiments, the photoinitiator may be configured to generate a free radical after exposure to light wherein the free radical initiates a chain reaction between the crosslinking component and the at least one monomer and/or oligomer to provide one or more polymer chains within a volume of the photopolymerizable resin. In some embodiments, the chain transfer agent may be configured to reinitiate the chain reaction to provide one or more new polymer chains within a volume of the photopolymerizable resin.

The cure rate of resin layers may depend on the tendency the resin components to polymerize by free radical reactions during curing by a light source (e.g., an ultraviolet light). The resin may optionally comprise a photoinitiator or inhibitor that may be used to speed or retard the curing process. A layer of resin of the disclosure, when provided in a thickness suitable for 3D printing or other additive manufacturing, may be able to photocure in time lengths desired for efficient production of an article. For example, in some cases, a layer of the resin about 100 $\mu$m thick may be configured to form a cured material in no more than 30 seconds, no more than 20 seconds, no more than 10 seconds, no more than 3 seconds, no more than 1 second, or no more than 1/10 of a second. In other cases, a layer of the resin about 400 $\mu$m thick may be configured to form a cured material in no more than 1 second. In other cases, a layer of the resin about 300 $\mu$m thick may be configured to form a cured material in no more than 1 second. In other cases, a layer of the resin about 200 $\mu$m thick may be configured to form a cured material in no more than 1 second. In other cases, a layer of the resin about 1000 $\mu$m thick may be configured to form a cured material in no more than 30 seconds. In other cases, a layer of the resin about 10 $\mu$m thick may be configured to form a cured material in no more than 2 seconds, no more than 1 seconds, no more than ½ a second, or no more than ¼ of a second.

Another embodiment of the invention includes a photopolymerizable resin for additive manufacturing, the resin comprising: at least at least one monomer and/or oligomer; and less than about 5% of a thiol, wherein the resin may be configured to react by exposure to light to form a cured material. In some cases, the resin may be configured to form a cured material in an aerobic environment.

Although thiols have a bad odor, the thiol-acrylate resin may have little to no discernable smell. It is thought that the low-smell characteristic results, at least in part, from the use of high molecular weight thiols in less than stoichiometric amounts to reduce or eliminate thiol odor. Further, the thiol may become almost completely incorporated into the polymer network.

Thiol volatiles may result from cured materials or during manufacturing processes that use thiols. The thiol volatiles may be tailored to be below thresholds detectable to human scent. This may be achieved, for example, by the resin comprising less than about 5% of a thiol. Thiol volatiles may be measured in a sample by use of a gas chromatography mass spectrometer (GC-MS). In some cases, the cured material contains less than 1 part per 100 million of thiol volatiles at ambient temperature and pressure over 50 seconds in an oxygen environment. In some cases, the cured material contains less than 1 part per 10 billion of thiol volatiles at ambient temperature and pressure over 50 seconds in an oxygen environment. In some cases, the cured material contains less than 1 part per 1 billion of thiol volatiles at ambient temperature and pressure over 50 seconds in an oxygen environment. In some embodiments, the cured material contains less than 1 part per 10 billion of thiol volatiles at ambient temperature and pressure over 50 seconds in an oxygen environment.

The at least one monomer and/or oligomer and the thiol used for additive manufacturing may be any monomer and/or oligomer or thiol compound as described for the resin of the disclosure. For example, the at least one monomer and/or oligomer includes an alkene, an alkyne, an acrylate or acrylamide, methacrylate, epoxide, maleimide, and/or isocyanate,

In some cases, the thiol has a molecular weight greater than about 200 or greater than about 500. In some embodiments, the thiol has a molecular weight greater than about 100 and contains moieties including hydrogen bond acceptors and/or hydrogen bond donors, wherein said moieties undergo hydrogen bonding.

In some cases, the resin includes the thiol and the at least one monomer and/or oligomer in about a stoichiometric ratio. In other embodiments, the thiol is less than about 20% by weight of the resin, less than about 10% by weight of the resin, or less than about 5% by weight of the resin.

In other cases, the thiol includes an ester-free thiol. In some embodiments, the thiol includes a hydrolytically stable thiol. In some embodiments, the thiol includes a tertiary thiol.

The cure rate may be such that a layer of the photopolymerizable resin about 100 $\mu$m thick is configured to cure in no more than 30 seconds. The materials may have a strain at break greater than 100%, up to 1000%. The materials have a toughness of between about 30 MJ/m$^3$ and about 100 MJ/m$^3$

In some embodiments, the resin comprises at least about 50% of one or more acrylic monomers and about 0-45% of one or more acrylic-functionalized oligomers. The thiol-acrylate resin can be stored as a single pot system at room temperature. In some cases, the components of the resin can be combined and stored in a single pot (e.g., a suitable container for chemical storage) for at least 6 months at room temperature with no more than 10-20% increase in the viscosity of the resin. (See, e.g., Example 9). In some cases, the components of the resin mixture can be combined and stored in a single pot for at least 6 months at room temperature with no more than 2%, 5%, 10%, 25%, 50% or 100% increase in the viscosity of the resin.

Stabilized thiols may be any thiol that exhibits fewer ambient thermal reactions (e.g., nucleophilic substitution with monomers or oligomers) compared to other thiols. In some cases, the stabilized thiol includes a bulky side chain. Such bulky side chains may include at least one chemical group, such as a C1-C18 cyclic, branched, or straight alkyl, aryl, or heteroaryl group. In some cases, the stabilized thiol includes a secondary thiol. In other cases, the stabilized thiol includes a multi-functional thiol. In some cases, the stabilized thiol includes at least one of a difunctional, trifunctional, and/or tetrafunctional thiol. In some embodiments, the stabilized thiol includes at least one of a Pentaerythritol tetrakis (3-mercaptobutylate); and/or 1,4-bis (3-mercaptobutylyloxy) butane.

The thiol-acrylate photopolymerizable resin may demonstrate improved shelf-stability. Resin compositions containing thiols and non-thiol reactive species such as -enes and acrylates may undergo a dark reaction (i.e, an ambient thermal free-radical polymerization or Michael Addition), which reduces the shelf-life of these compositions. To account for lower shelf-life of these resins, they may either be stored under cold conditions or as a two-pot system. By contrast, thiol-acrylate resins such as those of the disclosed materials may include a stabilized thiol (e.g., a secondary thiol). The stabilized thiol may have decreased reactivity, which can potentially increase the shelf-life of 3D printable resin compositions and enable storage as a single-pot resin system at room temperature. Moreover, the resin remaining at completion of a 3D printing run may be reused in a subsequent run.

In some embodiments, the components of the resin mixture can be combined and stored in a single pot for at least 6 months at room temperature with no more than 10% increase in the viscosity of the resin. The increased shelf life, pot life and/or print life may be due, at least in part, to the presence of a stabilized thiol in the resin mixture. Resin compositions containing thiols and non-thiol reactive species, for example acrylates, can undergo a dark reaction (i.e, ambient thermal free-radical polymerizations or nucleophilic Michael additions). The stabilized thiol, however, may have reduced reactivity in the dark reaction.

In some cases, the resin may be configured for continuous use in a 3D printing operation in an air environment for a period of 2 weeks without an increase in viscosity of more than 2%, 5%, 10%, 25, 50% or 100% increase in the viscosity of the resin. In some cases, the resin may be configured for continuous use in a 3D printing operation in an air environment for a period of 4 weeks without an increase in viscosity of more than 2%, 5%, 10%, 25, 50% or 100% increase in the viscosity of the resin. In some cases, the resin may be configured for continuous use in a 3D printing operation in an air environment for a period of 10 weeks without an increase in viscosity of more than 2%, 5%, 10%, 25%, 50%, or 100% increase in the viscosity of the resin. In some cases, the resin may be configured for continuous use in a 3D printing operation in an air environment for a period of 26 weeks without an increase in viscosity of more than 2%, 5%, 10%, 25%, 50%, or 100% increase in the viscosity of the resin. In some cases, the resin may be configured for continuous use in a 3D printing operation in an air environment for a period of 1 year without an increase in viscosity of more than 2%, 5%, 10%, 25%, 50%, or 100% increase in the viscosity of the resin.

In other cases, the at least one monomer and/or oligomer includes one or more acrylic monomers. In some embodiments, the one or more acrylic monomers are at least about 50% by weight of the resin. In other cases, the resin comprises less than about 5% of a stabilized thiol comprising one or more thiol functional groups, wherein the stabilized thiol may be configured to inhibit a nucleophilic substitution reaction between the one or more thiol functional groups and the one or more monomers or oligomers.

Other embodiments of the invention may include a photopolymerizable resin for additive manufacturing, the resin comprising: less than about 5% of a thiol, at least about 50% of one or more monomers; wherein the resin may be configured to react by exposure to light to form a cured material, wherein the cured material has a toughness in the range about 3-100 MJ/m$^3$ and a strain at break in the range about 30-1000%.

The cured thiol-acrylate resin may further exhibit time temperature superposition, so its properties change with temperature and frequency. At temperatures below the glass transition onset, the material is glassy and brittle. But, at temperatures above onset, the materia mayl becomes a viscoelastic and tough until the offset of the glass transition. The thiol-acrylate resin may have a glass transition temperature near use temperature. For example, the resin may have an onset of $T_g$ near 20°C.

At temperatures above the onset of $T_g$, the thiol-acrylate resin can be a high strain, tough material. Specifically, the cured thiol-acrylate resin exhibits a toughness of between 3-100 MJ/m$^3$ and strain at failure between 30-800%.

The cured materials in the present disclosure may provide mechanical properties that are tough and flexible (measured, e.g., by percent strain at break) that may be suitable for use in manufactured articles in which these properties are desired (e.g., shoe midsoles, insoles, outsoles). Articles comprising these cured materials may thus be produced at reduced expense with more possible efficiency and customizability of article designs and mechanical properties in an additive manufacturing process. For example, customization of toughness and flexibility may be demonstrated in the cured resins materials disclosed in Examples 1-8.

Due to the materials properties of the thiol-acrylate resin, articles 3D printed from the resin may be used in a variety of applications. Specific applications may include mattresses, game pieces and other at-home widgets, as well as articles worn on the body, or used in the body or ear. The resin may also be suitable for form and fit prototypes. For example, the resin may be used to produce low-cost shoe soles (midsoles, insoles, outsoles) for test manufacturing. In another embodiment, the resin, over a broad temperatures range (e.g. 0°C to 80°C), has a toughness of between 3 and 100 MJ/m$^3$ and strain at failure between 200 and 1000%. Articles 3D printed from the resin may be used in a variety of applications. Specific applications may include seals, gaskets, hoses, dampers, midsoles, car parts, aerospace components. It may also be suitable for form, fit and function prototypes. For example, it may be used to produce low-density, engineered shoe soles (midsoles, insoles, outsoles) for full-scale manufacturing.

Specifically, toughness may be customized by controlling the percentage and type of monomers with optional combination of additional oligomers, fillers, and additives. Control of these parameters may allow specific design of the materials elongation capacity (strain) and the force at which this elongation occurs (stress). Taken together, the stress/strain behavior of a material may impact its fracture toughness. In some cases, the cured material has a toughness of about 3 MJ/m$^3$ (see, e.g., Examples 7 and 8). In some cases, the cured material has a toughness of about 5 MJ/m$^3$ (see, e.g., Examples 5 and 6). In some cases, the cured material has a toughness of about 10 MJ/m$^3$ (see, e.g., Examples 1 and 5). In some cases, the cured material has a toughness of about 15-25 MJ/m$^3$ (see, e.g., Example 6). In some cases, the cured material has a toughness of about 30-100 MJ/m$^3$ (see, e.g., Example 6 and 8).

Additionally, the strain at break may be customized by controlling the percentage and type of monomers with optional combination of additional oligomers, fillers, and additives. Control of the underlying network morphology, the density between crosslinks, and the tear strength of the material (enabled by filler and matrix-filler interactions) may allow control over the elongation (strain) of the material. In some cases, the cured material has a strain at break of about 100%. In some cases, the cured material has a strain at break of about 200%. In some cases, the cured material has a strain at break of about 300%. In some cases, the cured material has a strain at break of about 400%. In some cases, the cured material has a strain at break of about 500%. In some cases, the cured material has a strain at break of about 600%. In some cases, the cured material has a strain at break of about 700%. In some cases, the cured material has a strain at break of about 800%.

In specific cases, the cured material has a toughness in the range about 3-30 MJ/m$^3$ and a strain at break ranging in the range about 30-300%. In other cases, the cured material has a toughness in the range about 8-15 MJ/m$^3$. In some cases, the cured material has a toughness less than about 1 MJ/m$^3$. In some cases, the cured material has a strain at break in the range about 50-250%. In some cases, the cured material has a glass transition temperature in the range about 10-30°C. In other cases, the resin has a toughness in the range about 3-100 MJ/m$^3$ and a strain at break in the range about 200-1000%. In some cases, the cured material has a toughness in the range about 3-8 MJ/m$^3$. In some cases, the cured material has a strain at break in the range about 350-500%. In some cases, the cured material has a toughness in the range about 3-30 MJ/m$^3$ at about 20°C. In other cases, the cured material has a toughness of about 10 MJ/m$^3$ at about 20°C. In some embodiments, the cured material has a strain at break in the range about 30-100% at about 20°C. In some cases, the cured material has a glass transition temperature in the range about 10-30°C. In some cases, the cured material has a Shore A hardness of about 95 at about 20°C. In some cases, the cured material has a toughness in the range about 1-5 MJ/m$^3$ at about 20°C. In specific cases, the cured material has a toughness of

about 3 MJ/m$^3$ at about 20°C.

In specific cases, the cured material has a toughness in the range about 20-40 MJ/m$^3$ at about 20°C. In other cases, the cured material has a toughness of about 40 MJ/m$^3$ at about 0°C. In other cases, the cured material has a toughness of about 30 MJ/m$^3$ at about 20°C. In other embodiments, the cured material has a toughness of about 20 MJ/m$^3$ at about 40°C. In other embodiments, the cured material has a toughness of about 1 MJ/m$^3$ at about 80°C.

In some cases, the cured material has a strain at break in the range about 250-300% at about 0°C. In some embodiments, the cured material has a strain at break in the range about 400-500% at about 20°C. In some cases, the cured material has a strain at break in the range about 400-500% at about 40°C. In some embodiments, the cured material has a strain at break in the range about 275-375% at about 80°C. In some embodiments, the cured material has a glass transition temperature in the range about 35-55°C.

The cure rate of resin layers may depend on the tendency the resin components to polymerize by free radical reactions during curing by a light source (e.g., an ultraviolet light). The resin may optionally comprise a photoinitiator or inhibitor that may be used to speed or retard the curing process. A layer of resin of the disclosure, when provided in a thickness suitable for 3D printing or other additive manufacturing, may be able to photocure in time lengths desired for efficient production of an article. The cure rate may be such that a layer of the photopolymerizable resin about 100 $\mu$m thick is configured to cure in no more than 30 seconds. For example, in some cases, a layer of the resin about 100 $\mu$m thick may be configured to form a cured material in no more than 30 seconds, no more than 20 seconds, no more than 10 seconds, no more than 3 seconds, no more than 1 second, or no more than 1/10 of a second. In other cases, a layer of the resin about 400 $\mu$m thick may be configured to form a cured material in no more than 1 second. In other cases, a layer of the resin about 300 $\mu$m thick may be configured to form a cured material in no more than 1 second. In other cases, a layer of the resin about 200 $\mu$m thick may be configured to form a cured material in no more than 1 second. In other cases, a layer of the resin about 1000 $\mu$m thick may be configured to form a cured material in no more than 30 seconds. In other cases, a layer of the resin about 10 $\mu$m thick may be configured to form a cured material in no more than 2 seconds, no more than 1 seconds, no more than ½ a second, or no more than ¼ of a second.

The cured material may also have a desired hardness suitable for manufactured articles. In some cases, the cured material has a Shore A hardness of about 30 at about 20°C. In some cases, the cured material has a Shore A hardness of about 90 at about 20°C.

The glass transition temperature ($T_g$) of the cured material is the temperature at which a polymer goes from an amorphous rigid state to a more flexible state. The glass transition temperature of the cured material may be customized by controlling the percentage and type of monomer, the percentage and type of oligomer, filler, plasticizer and curing additives (e.g., dye, initiator, or inhibitor). In some cases, the cured material has a glass transition temperature in the range about 10°C to about - 30°C, In some embodiments, the cured material has a glass transition temperature with a full width half max of more than 20°C, more than 30°C, more than 40°C, or more than 50°C. In specific cases the cured material has a glass transition temperature with a full width half max of more than 50°C.

Additionally, the cured material is in a glassy state below the glass transition temperature, and the cured material is in a tough state above the glass transition temperature. In some cases, a tough state occurs in the range about 5-50°C. In some cases, the tough state occurs in the range about 20-40°C. In some cases, the resin has a glass transition temperature is in the range about 20-25°C.

The materials may have a strain at break greater than 100%, up to 1000%. The materials may have a toughness of between about 30 MJ/m$^3$ and about 100 MJ/m$^3$. In specific cases, the cured material has a strain at break in the range about 400-500% at about 20°C. In some cases, the cured material has a glass transition temperature in the range about 10-30°C. In some cases, the cured material has a Shore A hardness of about 30 at about 20°C. In some cases, the cured material has a Shore A hardness of about 19 at about 20°C. In some cases, the cured material in the tough state has a toughness in the range about 3- 30 MJ/m$^3$. In some embodiments, the cured material in the tough state has a toughness in the range about 30-100 MJ/m$^3$. In some cases, the cured material in the glassy state has an elastic modulus less than 5 GPa, greater than 2 GPa, or greater than 1 GPa. In some cases, the cured material in the glassy state has an elastic modulus between 2 and 5 GPa.

Further embodiments of the invention may include a photopolymerizable resin for additive manufacturing, the resin comprising: less than about 5% of a thiol, at least about 50% of one or more monomers; and a photoinitiator, wherein the photoinitiator may be configured to form a free radical after exposure to light, such that the free radical initiates growth of one or more polymer chains including at least the difunctional and monofunctional monomers; wherein the resin may be configured to react by exposure to light to form a cured material, wherein the cured material has a glass transition temperature in the range about 5-30°C.

In specific cases, the resin further comprises a difunctional oligomer. In some cases, the difunctional oligomer is less than about 45% by weight of the resin. In some cases, the thiol is about ½-5% by weight of the resin. In some cases, the one or more monomers is about 1-95% by weight of the resin. In some cases, the photoinitiator is 0.01-3% by weight of the resin.

The resin may further comprise a trifunctional monomer. In some cases, the trifunctional monomer includes trimethylolpropane triacrylate.

Another embodiment of the invention provides a photopolymerizable resin for additive manufacturing, the resin comprising: about 5-15 parts per hundred rubber ("phr") of a thiol; about 20-60% of a difunctional acrylic oligomer; and about 40-80% of one or more monofunctional acrylic monomers; wherein the resin may be configured to react by exposure to light to form a cured material.

A further embodiment of the invention provides a photopolymerizable resin for additive manufacturing, the resin comprising: about 4 to 6 phr of Pentaerythritol tetrakis (3-mercaptobutylate); about 40% to 50% of CN9167; and about 50% to 60% of hydroxypropyl acrylate; wherein the resin may be configured to react by exposure to light to form a cured material.

Another embodiment of the invention provides a photopolymerizable resin for three-dimensional printing, the resin comprising: about 5-20 phr of a thiol; about 0-5 phr of polydimethylsiloxane acrylate copolymer; about 20-100% of a difunctional acrylic oligomer; and about 0-80% of at least one of a monofunctional acrylic monomer; wherein the resin may be configured to react by exposure to light to form a cured material.

Another embodiment of the invention provides a photopolymerizable resin for three-dimensional printing, the resin comprising: about 4 to 6 phr of Pentaerythritol tetrakis (3-mercaptobutylate); about 20% to 40% of CN9004; and about 60% to 80% of hydroxypropyl acrylate; wherein the resin may be configured to react by exposure to light to form a cured material.

Another aspect of the invention provides a photopolymerizable resin for three-dimensional printing, the resin comprising: about 5-10 phr of a thiol; about 0-20% of trimethylolpropane triacrylate; about 30-50% of at least one of a difunctional acrylic oligomer; about 50-86% of isobornyl acrylate; and about 0-21% of hydroxypropyl acrylate; wherein the resin may be configured to react by exposure to light to form a cured material.

Another aspect of the invention provides a photopolymerizable resin for three-dimensional printing, the resin comprising: about 4 to 6 phr of Pentaerythritol tetrakis (3-mercaptobutylate); about 0% to 5% of Trimethylolpropane triacrylate; about 25% to 35% of CN9004; and about 65% to 75% of Isobornyl acrylate; wherein the resin may be configured to react by exposure to light to form a cured material.

Another embodiment of the invention provides a photopolymerizable resin for three-dimensional printing, the resin comprising: about 5-10 phr of a thiol; about 0-5% of trimethylolpropane triacrylate; about 30-50% of at least one of a difunctional acrylic oligomer; about 5-75% of isobornyl acrylate; and about 0-80% of hydroxypropyl acrylate; wherein the resin may be configured to react by exposure to light to form a cured material.

## Additive Manufacturing of Resins

A photopolymerizable resin for additive manufacturing can be prepared in accordance with the following procedure.

Resins can be printed in a Top-Down, DLP printer (such as the Octave Light R1), in open atmosphere and ambient conditions. The printing vat may be loaded with Z-fluid (usually, 70 - 95% of the total volume), and then printing resin is put atop the Z-fluid (in commensurate levels; i.e. 5 - 30%). Printing parameters are input into the controlling software: exposure time (which usually ranges from 0.1 - 20 seconds), layer height (which usually ranges from 10 - 300 micrometers), and the surface is recoated between each layer in 0.25 - 10 seconds. A computer-aided design ("CAD") file is loaded into the software, oriented and supported as necessary, and the print is initiated. The print cycle is: the build-table descends to allow the resin to coat the surface, ascends to a layer-height (also called the Z-axis resolution) below the resin surface, the recoater blade smooths the surface of the resin, and the optical engine exposes a mask (cross-sectional image of the printed part, at the current height) causing the liquid resin to gel. The process repeats, layer by layer, until the article is finished printing. In some embodiments, the 3D printed resin parts are post-processed by curing at a temperature between 0-100°C for between 0 to 5 hours under UV irradiation of 350-400 nm.

## Experimental Techniques

The photopolymerizable resins for additive manufacturing can be characterized by use of the following techniques.

## Tensile Testing

Uniaxial tensile testing was performed on a Lloyd Instruments LR5K Plus Universal Testing Machine with a Laserscan 200 laser extensometer. Test specimens of cured material were prepared, with dimensions in accordance with ASTM standard D638 Type V. The test specimen was placed in the grips of the testing machine. The distance between the ends of the gripping surfaces was recorded. After setting the speed of testing at the proper rate, the machine was started. The load-extension cure of the specimen was recorded. The load and extension at the moment of rupture was recorded. Testing and measurements were performed in accordance with ASTM D638 guidelines.

**Toughness**

Toughness was measured using an ASTM D638 standard tensile test as described above. The dimensions of the Type V dogbone specimen were as follows:

$$[\text{Width of narrow section (W)} = 3.18 \pm 0.03 \text{ mm};$$

$$\text{Length of narrow section (L)} = 9.53 \pm 0.08 \text{ mm};$$

$$\text{Gage length (G)} = 7.62 \pm 0.02 \text{ mm};$$

$$\text{Radius of fillet (R)} = 12.7 \pm 0.08 \text{ mm}$$

Tensile testing was performed using a speed of testing of 100 mm/min. For each test, the energy required to break was determines from the area under the load trace up to the point at which rupture occurred (denoted by sudden load drop). This energy was then [describe calculation], to obtain the toughness $(MJ/m^3)$

**Strain at Break**

Strain at break was measured using an ASTM D638 standard tensile test as described above. The dimensions of the Type V dogbone specimen were as follows:

$$[\text{Width of narrow section (W)} = 3.18 \pm 0.03 \text{ mm};$$

$$\text{Length of narrow section (L)} = 9.53 \pm 0.08 \text{ mm};$$

$$\text{Gage length (G)} = 7.62 \pm 0.02 \text{ mm};$$

$$\text{Radius of fillet (R)} = 12.7 \pm 0.08 \text{ mm}$$

Tensile testing was performed using a speed of testing of 100 mm/min. For each test, the extension at the point of rupture was divided by the original grip separation (i.e. the distance between the ends of the gripping surfaces) and multiplied by 100.

**Differential scanning calorimetry**

Differential scanning calorimetry (DSC) measurements were performed on a Mettler Toledo DSC-1. A test specimen of 3-10 mg of cured material was placed in the sample holder. Testing was conducted in a 40 ml/min nitrogen purge gas atmosphere at a temperature variation of 10°C/min for three heat-cool cycles. Glass Transition Temperature (Tg) was measured via a straight line approximation of the mid-point between the on-set and off-set of the glass transition slopes. DSC testing was performed in accordance with ASTM E1356 Guidelines.

**Dynamic Mechanical Analysis (DMA)**

Dynamic Mechanical Analysis (DMA) measurements were performed on a Mettler Toledo DMA-861. A test specimen of cured material 12 mm long, 3 mm wide, and 0.025-1.0 mm thick was used. The specimen was subjected to a tensile force at 1 Hz with a maximum amplitude of 10 N and a maximum displacement of 15 $\mu$m. Glass Transition Temperature (Tg) was measured as the peak of Tan Delta (the ratio of the loss and storage moduli). DMA testing was performed in accordance with ASTM D4065 guidelines.

**Cure Rate**

A sample of a given resin (approx. 1 g - 10 g) is placed into a container. The container is placed below an optical engine tuned to the initiator in the resin (i.e., a 385 nm light source for resin including an initiator such as TPO (Diphenyl(2,4,6-trimethylbenzoyl)phosphine oxide)), so that the resin is directly in the center of the projection area. A sample image (e.g. a 1 cm x 1 cm square) is projected onto the resin for a given amount of time (usually 0.1 - 20 seconds). The amount of time for an initial exposure is determined. The surface of the resin sample is inspected to determine if a gel has formed. If a manipulable gel that can be removed from the resin bath with forceps and laid out on a sheet with fixed geometry (i.e., a square) has not formed, a new sample is generated with increased exposure time, and the test is repeated until a gel is successfully formed from a single exposure to approximate of the gelation point. The Depth of Cure (DOC) recorded is the exposure time required for gelation.

**Hardness**

Hardness was obtained using a Shore A Durometer (1-100 HA $\pm$ 0.5 HA). Hardness testing was performed in accordance with ASTM D2240 guidelines.

**Viscosity**

Viscosity (mPa·s) was obtained using a Brookfield LV-1 viscometer. Viscosity testing was performed in accordance with ASTM D2196 guidelines.

**EXAMPLES**

The present invention will now be further illustrated by reference to the accompanying examples.

**Preparation of Resins**

A photopolymerizable resin for additive manufacturing was prepared in accordance with the following procedure.
Monomers (e.g., mono- and multi-functional acrylates), solids (e.g., initiators, inhibitors, dyes), and thiols are added to an amber bottle (1000 mL, HDPE) and mixed in a ultrasonic bath (Bransonic CPX2800H, Branson Ultrasonic Corporation, CT) at 25 °C for 30 minutes to form a clear solution. Oligomers are heated to 80 °C in an oven (OV-12, Jeio Tech, Korea) and are subsequently added to the amber bottle. The bottle is placed in the ultrasonic bath and chemicals are mixed at 25 °C for 30 minutes. Afterwards, the bottle is removed from the ultrasonic bath and is shaken by hands for 5 minutes. The bottle is again placed in the ultrasonic bath and chemicals are mixed at 25 °C for 30 minutes to form a clear resin.

**Preparation of Cast Samples for Testing**

A cast sample for testing of the photopolymerizable resin for additive manufacturing was prepared in accordance with the following procedure.
A mold (e.g., glass or silicone) was filled with resin and placed into a UV Cure Oven (UVP CL-1000L, broad UV range with peak at 365 nm) for approximately 20 to 30 minutes to allow the resin to cure. The cured material was then removed from the mold. The resulting cast sample of cured material was characterized using experimental techniques.

**Example 1: Composition F13**

A thiol-acrylate resin consisting of the components shown in Table 1 was prepared.

**TABLE 1**

| Component | Weight % |
| --- | --- |
| hydroxypropyl acrylate | 55 |
| CN9167 | 45 |

(continued)

| Component | Weight % |
|---|---|
| PE1 | 5 phr |

The resin had a viscosity of 58 cP at 20 °C.

The resin was photocured to form a cast sample for testing. Physical and mechanical property tests were performed on the sample.

The composition F13 had an onset of its glass transition temperature of 20°C. The resin behaves as a viscoelastic, tough material at temperatures between 15°C and 40°C. At about the onset temperature, composition F13 had a toughness of 9.58 MJ/m$^3$. It had a strain at failure of 66.1 %. Additionally, the resin had a hardness of 96 shore A.

**Example 2: Composition H6**

A thiol-acrylate resin consisting of the components shown in Table 2 was prepared.

**TABLE 2**

| Component | Weight % |
|---|---|
| Isobornyl acrylate | 68 |
| Trimethylol propane triacrylate | 2 |
| CN9004 | 30 |
| PE1 | 5 phr |

The resin had a viscosity of 504cP at 20°C. The resin was photocured to form a cast sample for testing. Physical and mechanical property tests were performed on the sample.

The resin had a toughness of 30.05 MJ/m$^3$ and a strain at failure of 447% at 20 °C. The resin behaves as a viscoelastic, tough material at temperatures between -30°C and 85°C. Additionally, the resin had a hardness of 75 shore A (see

Fig. 2).

**Example 3: Composition D8**

A thiol-acrylate resin consisting of the components shown in Table 3 was prepared.

**TABLE 3**

| Component | Weight % |
|---|---|
| Hydroxypropyl acrylate | 70 |
| CN9004 | 30 |
| PE1 | 5 phr |

Specifically, HPA (663.3 g), TPO (4.7 g), BBOT (0.24 g), and PE1 (47.4 g) were added to the amber bottle and mixed in the ultrasonic bath at 25 °C for 30 minutes to form a clear solution. CN9004 (284.3 g) was heated to 80 °C in the oven and was subsequently added to the amber bottle. The bottle is placed in the ultrasonic bath and chemicals are mixed at 25 °C for 30 minutes. Afterwards, the bottle is removed from the ultrasonic bath and is shaken by hands for 5 minutes. The bottle is again placed in the ultrasonic bath and chemicals are mixed at 25 °C for 30 minutes to form a clear resin.

The resin was photocured to form a cast sample for testing. Physical and mechanical property tests were performed on the sample. The resin had the onset of its glass transition temperature at about -15°C, a midpoint at about 15°C and an offset of above 60 °C. At room temperature (20 °C), it had a toughness of about 3 MJ/m$^3$ and a strain at failure of 400-500%. The resin behaves as a viscoelastic, tough material at temperatures between -10°C and 40°C. Additionally, resin was an ultra-soft material with an instantaneous hardness of 30 shore A and relaxing to 19 Shore A after several seconds.

**Example 4**

The resins shown in Table 4 were prepared as described above

**TABLE 4**

| RESIN | COMPONENT (%) | | | | | | | | | | ADDITIVES (phr) | | | | |
|---|---|---|---|---|---|---|---|---|---|---|---|---|---|---|---|
| | Monomers | | | | | | | Oligomers | | | Thiols | | | Others | |
| | EA | EHA | HPA | SR531 | IBOA | BA | 2HEMA | PEGDA | CN9167 | CN9004 | PE1 | BD1 | NR1 | ACR | Silica |
| D1 | | | | | 4 | | | | | 48 | 5 | | | | |
| D2.3 | | | | | | 63 | | | | 30 | 5 | | | 2 | |
| D2.4 | | | | | | 60 | | | | 30 | 5 | | | 5 | |
| D2.5 | | | | | | 50 | | | | 40 | 5 | | | 5 | |
| D5 | | | | 48 | | | | | | 48 | 5 | | | | |
| D5.1 | | | | 68 | | | | | | 32 | 5 | | | 2 | |
| D5.1NT | | | | 68 | | | | | | 32 | 0 | | | 2 | |
| D5.2 | | | | 32 | | 32 | | | | 30 | 5 | | | 2 | |
| D5.3 | | | | 48 | | | | | 48 | | 5 | | | | |
| D5.4 | | | | | | | | | | 40 | 5 | | | 5 | |
| D6.2 | | | | 68 | | | | | | 32 | 5 | | | 2 | 5 |
| D6.6 | | 20 | | 60 | | | | | | 20 | 5 | | | 2 | |
| D6.6.1 | | 20 | | 60 | | | | | | 20 | 5 | | | 2 | 5 |
| D6.7 | | 20 | | 50 | | | | | | 30 | 5 | | | 2 | |
| D6.7.1 | | 20 | | 50 | | | | | | 30 | 5 | | | 2 | 5 |
| D6.8 | | 10 | 10 | 50 | | | | | | 30 | 5 | | | 2 | |
| D6.8.1 | | 10 | 10 | 50 | | | | | | 30 | 5 | | | 2 | 5 |
| D 6.9 | | 30 | | 40 | | | | | | 30 | 5 | | | 2 | |
| D7.1 | | 50 | | 20 | | | | | | 30 | 5 | | | 2 | |
| D7.3 | | 40 | | 30 | | | | | | 30 | 5 | | | 2 | |
| D8.0 | | | | 70 | | | | | | 30 | 5 | | | 2 | |
| D8.0NT | | | | 70 | | | | | | 30 | 0 | | | 2 | |
| D8.1 | | | | 70 | | | | | | 30 | 5 | | | 5 | |

EP 3 896 519 A1

(continued)

| | EA | EHA | | HPA | SR531 | IBOA | BA | 2HEMA | PEGDA | CN9167 | CN9004 | PE1 | BD1 | NR1 | ACR | Silica |
|---|---|---|---|---|---|---|---|---|---|---|---|---|---|---|---|---|
| D8.1.1 | | | | 70 | | | | | | | 30 | 5 | | | 5 | 5 |
| D8.1.3 | | | | 70 | | | | | | | 30 | 5 | | | 5 | 3 |
| D8.2 | | | | 35 | 35 | | | | | | 30 | 5 | | | 2 | |
| D8.4 | | 20 | | 20 | 30 | | | | | | 30 | 5 | | | 2 | |
| D9.0 | | | | | 40 | | | | 60 | | | 5 | | | 5 | |
| D9.1 | | | | | 60 | | | | 40 | | | 5 | | | 5 | |
| D11.0 | | | | | 55 | 15 | | | | 30 | | 5 | | | | |
| D11.0.1 | | | | | 55 | 15 | | | | 30 | | 5 | | | | 5 |
| D11.0NT.1 | | | | | 55 | 15 | | | | 30 | | 0 | | | | 5 |
| HP3 | 10 | 10 | | | 20 | 20 | 10 | | | 30 | | | | | | 2 |
| 2HEMA#8.1 | | | | 21 | | | | 49 | | | 30 | 5 | | | | |
| 2HEMA#8.2 | | | | 21 | | | | 49 | | | 30 | | 5 | | | |
| 2HEMA#8.3 | | | | 21 | | | | 49 | | | 30 | | | 5 | | |
| 2HEMA#8.4 | | | | 21 | | | | 49 | | | 30 | 10 | | | | |
| 2HEMA#8.5 | | | | | | | | 70 | | | 30 | 5 | | | | |

(continued)

| EA | EHA | | HPA | SR531 | IBOA | BA | 2HEMA | PEGDA | CN9167 | CN9004 | PE1 | BD1 | NR1 | ACR | Silica |
|---|---|---|---|---|---|---|---|---|---|---|---|---|---|---|---|
| 2HEMA#8.6 | | | | | | | 40 | | | 60 | 5 | | | | |

EA: Ethyl acrylate
EHA: Sigma Aldrich; Ethylhexyl acrylate
HPA: Sigma Aldrich; Hydroxypropyl acrylate
SR531: Sartomer; Cyclic trimethylolpropane formal acrylate
IBOA: Sigma Aldrich; Isobornyl acrylate
BA: Sigma Aldrich; Butyl acrylate
2HEMA: Sigma Aldrich; 2-Hydroxyethyl methacrylate
PEGDA: Sigma Aldrich; Poly(ethylene glycol) diacrylate
CN9167: Sartomer; aromatic urethane acrylate
CN9004: Sartomer; aliphatic urethane acrylate
PE1: Showa Denko; Pentaerythritol tetrakis (3-mercaptobutylate)
BD1: Showa Denko; 1,4-bis (3-mercaptobutylyloxy) butane
NR1: Showa Denko; 1,3,5-Tris(3-melcaptobutyloxethyl)-1,3,5-triazine-2,4,6(1H,3H,5H)-trione ACR: Siltech; Polydimethylsiloxane Acrylate Copolymer
Silica: Aerosil R 972

Each of the resins was photocured to form a cast sample for testing. The hardness was measured. Further, the mechanical properties were measured using uniaxial tensile testing. Also, depth of cure (DOC) was measured in the method described above. The results obtained are given in Table 5.

**TABLE 5**

| RESIN | Shore A | Toughness (MJ/m$^3$) | Strain (%) | Stress (MPa) | DOC (sec) |
|---|---|---|---|---|---|
| D2.3 | | 0 | | | |
| D2.4 | 8 | | | | |
| D2.5 | 21 | | | | 41 |
| D5 | 50 | | | | |
| D5.1 | 38 | | | | 4.1 |
| D5.2 | 32 | | | | |
| D5.4 | 50 | | | | |
| D6.6 | 30 | | | | 9 |
| D6.6.1 | 35 | | | | |
| D6.7 | 28 | | | | 6.5 |
| D6.7.1 | 35 | | | | |
| D6.8 | 40 | | | | 6 |
| D6.8.1 | 44 | | | | |
| D6.9 | 30 | | | | 7 |
| D7.3 | 25 | | | | 8.5 |
| D8.0 | 19 | | | | 11 |
| D8.0NT | 60 | | | | 4 |
| D8.1 | 20 | | | | 11 |
| D8.1.1 | 50-26 | | | | |
| D8.1.3 | 50-20 | | | | 11 |
| D8.2 | 40 | | | | |
| D8.4 | 30 | | | | 8 |
| 2HEMA#8.1 | | 34 | 272 | 17 | 30-60 |
| 2HEMA#8.2 | | 28 | 362 | 11 | 30-45 |
| 2HEMA#8.3 | | 26 | 209 | 16.2 | |
| 2HEMA#8.4 | | 18 | 463 | 4.76 | |
| 2HEMA#8.5 | 94 | 17.12 | 134 | 19.19 | -25 |
| 2HEMA#8.6 | 87 | | | | 20-25 |

**Example 5**

The resins shown in Table 6 were prepared as described above.

**TABLE 6**

| RESIN | COMPONENT (%) | | | | | | ADDITIVE (phr) | | | |
|---|---|---|---|---|---|---|---|---|---|---|
| | Monomers | | | | | Oligomer | Thiols | | | Other |
| | EHA | HPA | IBOA | BA | 2HEMA | CN9167 | PE1 | BD1 | NR1 | ACR |
| F1 | | 70 | | | | 30 | 5 | | | |
| F2 | | 80 | | | | 20 | 5 | | | |
| F3 | | 60 | | | | 40 | 5 | | | |
| F4 | | 70 | | | | 30 | | 10 | | 2 |
| F5 | | | | 70 | | 30 | 5 | | | |
| F6 | | | | | 60 | 40 | 5 | | | |
| F7 | 70 | | | | | 30 | 5 | | | |
| F8 | | 60 | | | 20 | 20 | 5 | | | |
| F9 | | 80 | | | | 20 | 5 | 5 | | |
| F10 | 30 | 30 | | | | 40 | 10 | | | |
| F11 | | 60 | | | | 40 | | | 5 | |
| F12 | | 60 | | | | 40 | | | 10 | |
| F13 | | 55 | | | | 45 | 5 | | | |
| F14 | | 50 | | | | 50 | 5 | | | |
| F15 | | 45 | | | | 55 | 5 | | | |
| F16 | | 40 | | | | 60 | 5 | | | |
| F18 | | 70 | | | | 30 | 15 | | | |
| F19 | | 70 | | | | 30 | | | 5 | |
| F21 | | 70 | | | | 30 | | | 15 | |
| F22 | | 60 | 10 | | | 30 | 15 | | | |
| F23 | | 50 | 20 | | | 30 | 15 | | | |

EHA: Sigma Aldrich; Ethylhexyl acrylate
HPA: Sigma Aldrich; Hydroxypropyl acrylate
SR531: Sartomer; Cyclic trimethylolpropane formal acrylate
IBOA: Sigma Aldrich; Isobornyl acrylate
BA: Sigma Aldrich; Butyl acrylate
2HEMA: Sigma Aldrich; 2-Hydroxyethyl methacrylate
CN9167: Sartomer; aromatic urethane acrylate
CN9004: Sartomer; aliphatic urethane acrylate
PE1: Showa Denko; Pentaerythritol tetrakis (3-mercaptobutylate)
BD1: Showa Denko; 1,4-bis (3-mercaptobutylyloxy) butane
NR1: Showa Denko; 1,3,5-Tris(3-melcaptobutyloxethyl)-1,3,5-triazine-2,4,6(1H,3H,5H)-trione
ACR: Siltech; Polydimethylsiloxane Acrylate Copolymer
Silica: Aerosil R 972

Each of the resins was photocured to form a cast sample for testing. The hardness was measured. Further, the mechanical properties were measured using uniaxial tensile testing. Also, depth of cure (DOC) was measured in the method described above. The results obtained are given in Table 7.

**TABLE 7**

| RESIN | Shore A | Toughness (MJ/m$^3$) | Strain (%) | Stress (MPa) | DOC (sec) |
|-------|---------|----------------------|------------|--------------|-----------|
| F1  | 90-65 | 1.55 | 89.2 | 3.83  | 4    |
| F2  | 70    | 0.99 | 105  | 2.15  | 6    |
| F3  | 90-80 | 6.45 | 85.7 | 13.91 | 3    |
| F4  | 40-35 | 0.41 | 89.7 | 1.02  |      |
| F5  | 58    |      |      |       |      |
| F6  | 98    |      |      |       | 30   |
| F7  | 60    |      |      |       | 18   |
| F8  | 60-50 | 0.43 | 78.9 | 1.14  | 15   |
| F9  | 70-30 | 0.61 | 145  | 0.95  | 11   |
| F10 | 72    | 0.28 | 35.1 | 1.58  | 4    |
| F11 | 96    | 7.78 | 74.4 | 15.19 | 2.5  |
| F12 | 94    | 3.93 | 89   | 8.44  | 2.75 |
| F13 | 96    | 9.58 | 66.1 | 17.93 | 2.25 |
| F14 |       | 4.34 | 30.1 | 16.88 | 2    |
| F15 |       |      |      |       | 2    |
| F16 |       |      |      |       | 1.5  |
| F18 |       | 0.65 | 115  | 1.2   | 5    |
| F19 |       |      |      |       | 3    |
| F21 |       |      |      |       | 3    |
| F22 |       | 0.7  | 111  | 1.4   | 5    |
| F23 |       | 1.74 | 151  | 3.05  | 5.5  |

## Example 6

The resins shown in Table 8 were prepared as described above.

**TABLE 8**

| RESIN | COMPONENT (%) | | | | | | Thiol (phr) |
|-------|---------------|---|---|---|---|---|-------------|
|       | Monomers | | | | Oligomers | | |
|       | HPA | IBOA | TMPTA | Bisacrylamide | PEGDA | CN9004 | PE1 |
| H2  |    | 70   |    |     |    | 30   | 5 |
| H5  |    | 69   | 1  |     |    | 30   | 5 |
| H6  |    | 68   | 2  |     |    | 30   | 5 |
| H7  |    | 65   | 5  |     |    | 30   | 5 |
| H8  |    | 60   | 10 |     |    | 30   | 5 |
| H9  |    | 69   |    |     | 1  | 30   | 5 |
| H10 |    | 68   |    |     | 2  | 30   | 5 |
| H11 |    | 65   |    |     | 5  | 30   | 5 |
| H12 |    | 60   |    |     | 10 | 30   | 5 |
| H13 | 21 | 54.4 |    | 0.8 |    | 23.8 | 5 |

(continued)

| RESIN | COMPONENT (%) | | | | | | Thiol (phr) |
|---|---|---|---|---|---|---|---|
| | Monomers | | | | Oligomers | | |
| | HPA | IBOA | TMPTA | Bisacrylamide | PEGDA | CN9004 | PE1 |
| H14 | 19 | 55 | | 1.6 | | 24.4 | 5 |

HPA: Sigma Aldrich; Hydroxypropyl acrylate
IBOA: Sigma Aldrich; Isobornyl acrylate
TMPTA: Sigma Aldrich; Trimethylolpropane triacrylate
Bisacrylamide: Sigma Aldrich; N,N'-Methylenebis(acrylamide)
PEGDA: Sigma Aldrich; Poly(ethylene glycol) diacrylate
CN9004: Sartomer; aliphatic urethane acrylate
PE1: Showa Denko; Pentaerythritol tetrakis (3-mercaptobutylate)

Each of the resins was photocured to form a cast sample for testing. The hardness was measured. Further, the mechanical properties were measured using uniaxial tensile testing. The results obtained are given in Table 9.

TABLE 9

| RESIN | Toughness (MJ/m³) | Strain (%) | Stress (MPa) | Stress (MPa) |
|---|---|---|---|---|
| H2 | 15.47 | 595 | 9.92 | |
| H5 | | | | 7-8 |
| H6 | 30.05 | 447 | 17.3 | 6-6.5 |
| H7 | 21.4 | 218 | 17.1 | 4-4.5 |
| H8 | 11.38 | 93.96 | 16.38 | "2-3 |
| H9 | | | | 8 |
| H10 | 23.91 | 453 | 16.34 | 6.5-7 |
| H11 | 17.04 | 258 | 16.53 | 4.5 |
| H12 | 9.97 | 134 | 14.3 | 3 |
| H13 | 23.83 | 403 | 12.08 | "7-8 |
| H14 | 24.46 | 333 | 13.61 | |

**Example 7**

The resins shown in Table 10 were prepared as described above.

TABLE 10

| RESIN | COMPONENTS (%) | | | | Thiol (phr) |
|---|---|---|---|---|---|
| | Monomers | | | Oligomer | |
| | HPA | IBOA | TMPTA | CN9004 | PE1 |
| T1 | 60 | 10 | | 30 | 5 |
| T2 | 50 | 20 | | 30 | 5 |
| T3 | 40 | 30 | | 30 | 5 |
| T4 | 30 | 40 | | 30 | 5 |
| T5 | 20 | 50 | | 30 | 5 |
| T6 | 10 | 60 | | 30 | 5 |

(continued)

| RESIN | COMPONENTS (%) | | | | Thiol (phr) |
|---|---|---|---|---|---|
| | Monomers | | | Oligomer | |
| | HPA | IBOA | TMPTA | CN9004 | PE1 |
| T7 | 5 | 65 | | 30 | 5 |
| T8 | 60 | 8 | 2 | 30 | 5 |
| T9 | 50 | 18 | 2 | 30 | 5 |
| T10 | 40 | 28 | 2 | 30 | 5 |
| T11 | 30 | 38 | 2 | 30 | 5 |
| T12 | 20 | 48 | 2 | 30 | 5 |
| T13 | 10 | 58 | 2 | 30 | 5 |
| T14 | 5 | 63 | 2 | 30 | 5 |
| T15 | 60 | 9 | 1 | 30 | 5 |
| T16 | 50 | 19 | 1 | 30 | 5 |
| T17 | 40 | 29 | 1 | 30 | 5 |
| T18 | 30 | 39 | 1 | 30 | 5 |
| T19 | 20 | 49 | 1 | 30 | 5 |
| T20 | 10 | 59 | 1 | 30 | 5 |
| T21 | 5 | 64 | 1 | 30 | 5 |
| HPA: Sigma Aldrich; Hydroxypropyl acrylate<br>IBOA: Sigma Aldrich; Isobornyl acrylate<br>TMPTA: Sigma Aldrich; Trimethylolpropane triacrylate<br>CN9004: Sartomer; aliphatic urethane acrylate<br>PE1: Showa Denko; Pentaerythritol tetrakis (3-mercaptobutylate) | | | | | |

Each of the resins was photocured to form a cast sample for testing. The hardness was measured. Further, the mechanical properties were measured using uniaxial tensile testing. Also, depth of cure (DOC) was measured in the method described above. The results obtained are given in Table 9.

**TABLE 11**

| RESIN | Shore A | Toughness (MJ/m3) | Strain (%) | Stress (MPa) | Viscosity at RT | Tg (°C) | DOC (sec) |
|---|---|---|---|---|---|---|---|
| T1 | 23 | 4.49 | 524 | 2.51 | 420 | 5 | 5.5 |
| T2 | 25 | 8.16 | 671 | 4.03 | 470 | 8 | 5.5 |
| T3 | 30 | 9.71 | 755 | 3.44 | | 14 | 6 |
| T4 | 37 | >7.91 | >700 | >2.86 | | 15 | 7.5 |
| T5 | 23 | >5.76 | >650 | >2.14 | 124 | | 8 |
| T6 | 20 | >10.96 | >650 | >5.63 | 360 | | 7.5 |
| T7 | 25 | 14.45 | 592 | 9.9 | | | 8 |
| T8 | 44 | 3.09 | 223 | 4.39 | | 14 | 3 |
| T9 | 44 | 9.31 | 283 | 11.6 | | 15 | 3 |
| T10 | 38 | | | | | 22 | 3.5 |

**Example 8**

The resins shown in Table 12 were prepared as described above.

TABLE 12

| RESIN | COMPONENTS (%) | | | | | ADDITIVES (phr) | | | | | |
|---|---|---|---|---|---|---|---|---|---|---|---|
| | Monomers | | | Oligomers | | PE1 | TPO | BBOT | CB | BHT | 0X50 |
| | HBA | IBOA | TMPTA | CN9004 | CN9028 | | | | | | |
| A121405 | 70 | | 1 | | 30 | 5 | | | | | 30 |
| A121406 | 70 | | 0.75 | | 30 | 5 | | | | | 30 |
| A 121407 | 70 | | 0.5 | | 30 | 5 | | | | | 30 |
| A121408 | 70 | | 0.25 | | 30 | 5 | | | | | 30 |
| A061901 | 40 | 30 | 1 | 30 | | 5 | 0.5 | 0.025 | | | |
| A061902 | 40 | 30 | 1 | 30 | | 5 | 0.5 | 0.025 | | | |
| A061903 | 40 | 30 | 1 | 30 | | 5 | 0.5 | 0.025 | | | |
| A111411 | | 68 | 2 | 30 | | 5 | 2 | 0.05 | | 0.2 | |
| A111415 | 10 | 58 | 2 | 2 | | 5 | 2 | 0.05 | | 0.2 | |
| A111413 | 38 | 30 | 2 | 2 | | 5 | 2 | 0.05 | | 0.2 | |
| A111414 | 45 | 23 | 2 | 2 | | 5 | 2 | 0.05 | | 0.2 | |
| A111412 | 40 | 30 | 0.1 | 0.1 | | 5 | 2 | 0.05 | | 0.2 | |
| B022000 | | 68 | 2 | 2 | | 5 | 2 | 0.05 | | 0.2 | |
| B022001 | | 69 | 1 | 1 | | 5 | 1 | 0.025 | | 0.1 | |
| B022002 | | 69.5 | 0.5 | 0.5 | | 5 | 1 | 0.025 | | 0.1 | |
| B022003 | 1 | 67 | 2 | 2 | | 5 | 1 | 0.025 | | 0.1 | |
| B022004 | 3 | 65 | 2 | 2 | | 5 | 1 | 0.025 | | 0.1 | |
| B022005 | 5 | 63 | 2 | 2 | | 5 | 1 | 0.025 | | 0.1 | |

HPA: Sigma Aldrich; Hydroxypropyl acrylate
IBOA: Sigma Aldrich; Isobornyl acrylate
TMPTA: Sigma Aldrich; Trimethylolpropane triacrylate
CN9004: Sartomer; aliphatic urethane acrylate
CB9028: Sartomer; aliphatic urethane acrylate
PE1: Showa Denko; Pentaerythritol tetrakis (3-mercaptobutylate)
TPO: Sigma Aldrich; Diphenyl(2,4,6-trimethylbenzoyl)phosphine oxide
BBOT: Sigma Aldrich; 2,5-Bis(5-tert-butyl-benzoxazol-2-yl)thiophene
CB: Carbon Black
BHT: Butylated hydroxytoluene (inhibitor)
OX50: Evonik; OH-functional Silica

Each of the resins was photocured to form a cast sample for testing. The hardness was measured. Further, the mechanical properties were measured using uniaxial tensile testing. Thermal analysis measurements were conducted using Dynamic Mechanical Analysis (DMA) and Differential scanning calorimetry (DSC) to determine Tg and Tan Delta values. The results obtained are given in Table 13.

**TABLE 13**

| RESIN | Shore A | | Tensile D638 | | | Thermal analysis | | |
|---|---|---|---|---|---|---|---|---|
| | 0 sec | 10 sec | Toughness | Elongation | Strength | DMA Tg | DSC Tan Delta | DSC Tg |
| A121405 | 44 | 43 | | | | | | |
| A121406 | 33 | 30 | | | | | | |
| A121407 | 23 | 20 | | | | | | |
| A121408 | 26 | 23 | | | | | | |
| A061901 | 40 | 30 | | | | | | |
| A061902 | 36 | 26 | 3.33 | 453 | 1.8 | | | |
| A061903 | 37 | 24 | 2.9 | 559 | 1.15 | | | |
| A111411 | 89 | 85 | 37.47 | 442 | 21.61 | 39.68 | 1.22 | |
| A111415 | 88 | 54 | 20.86 | 464 | 16.04 | | | 10 |
| A111413 | 58 | 43 | 3.48 | 260 | 4.73 | | | 0 |
| A111414 | 46 | 42 | 2.16 | 212 | 2.88 | | | -10 |
| A111412 | 39 | 23 | 3.94 | 643 | 1.77 | -2.62 | 1.55 | -5 |
| B022000 | 95 | 92 | | | | | | |
| B022001 | 93 | 87 | | | | | | |
| B022002 | 97 | 88 | | | | | | |
| B022003 | 93 | 89 | | | | | | |
| B022004 | 89 | 83 | | | | | | |
| B022005 | 88 | 77 | | | | | | |

## Example 9

The resins shown in Table 14 were prepared as described above. Original viscosity and viscosity after at least 6 months of the resin was measured to determine the viscosity percent change.

**TABLE 14**

| TABLE 14Resin | Time on Shelf | Original Viscosity (mPa·s) | >6 month Viscosity (mPa·s) | Viscosity Change (%) |
|---|---|---|---|---|
| F1 | ~8 months | 32 | 36 | 12.5 |
| F13 | >6 months | 83 | 93 | 12.3 |
| H6 | -10 months | 685 | 825 | 20.4 |

## Example 10

The resins shown in Table 15 were prepared as described above. Depth of cure (DOC) was measured in the method described above.

**TABLE 15**

| RESIN | Monomers (%) Oligomers (%) | | | | | | | | Additives (phr) | | | DOC (sec) |
|---|---|---|---|---|---|---|---|---|---|---|---|---|
| | EA | EHA | SR531 | IBOA | BA | PEGDA | CN9167 | CN9004 | PE1 | ACR | Silica | |
| D1 | | | | 48 | | | | 48 | 5 | | | 7 |
| D5.1 NT | | | 68 | | | | | 32 | 0 | 2 | | 3 |

(continued)

| RESIN | Monomers (%) Oligomers (%) | | | | | | | | Additives (phr) | | | DOC (sec) |
|---|---|---|---|---|---|---|---|---|---|---|---|---|
| | EA | EHA | SR531 | IBOA | BA | PEGDA | CN9167 | CN9004 | PE1 | ACR | Silica | |
| D5.3 | | | 48 | | | | 48 | | 5 | | | 5 |
| D6.2 | | | 68 | | | | | 32 | 5 | 2 | 5 | 4.5 |
| D7.1 | | 50 | 20 | | | | | 30 | 5 | 2 | | 35 |
| D9.0 | | | 40 | | | 60 | | | 5 | 5 | | 4 |
| D9.1 | | | 60 | | | 40 | | | 5 | 5 | | 5 |
| D11.0 | | | 55 | 15 | | | | 30 | 5 | | | 5.25 |
| D11.0.1 | | | 55 | 15 | | | | 30 | 5 | | 5 | 5.25 |
| HP3 | 10 | 10 | 20 | 20 | 10 | | | 30 | | 2 | | 4.5 |

EA: Ethyl acrylate
EHA: Sigma Aldrich; Ethylhexyl acrylate
SR531: Sartomer; Cyclic trimethylolpropane formal acrylate
IBOA: Sigma Aldrich; Isobornyl acrylate
BA: Sigma Aldrich; Butyl acrylate
PEGDA: Sigma Aldrich; Poly(ethylene glycol) diacrylate
CN9167: Sartomer; aromatic urethane acrylate
CN9004: Sartomer; aliphatic urethane acrylate
PE1: Showa Denko; Pentaerythritol tetrakis (3-mercaptobutylate)
ACR: Siltech; Polydimethylsiloxane Acrylate Copolymer
Silica: Aerosil R 972

## Example 11

The resins shown in Table 16 were prepared as described above. Depth of cure (DOC) was measured in the method described above.

**TABLE 16**

| RESIN | COMPONENTS (%) | | ADDITIVES (phr) | | DOC (sec) |
|---|---|---|---|---|---|
| | HPA | CN9167 | PE1 | NR1 | |
| F15 | 45 | 55 | 5 | | 2 |
| F16 | 40 | 60 | 5 | | 1.5 |
| F19 | 70 | 30 | | 5 | 3 |
| F21 | 70 | 30 | | 15 | 3 |

HPA: Sigma Aldrich; Hydroxypropyl acrylate
CN9167: Sartomer; aromatic urethane acrylate
PE1: Showa Denko; Pentaerythritol tetrakis (3-mercaptobutylate)
NR1: Showa Denko; 1,3,5-Tris(3-melcaptobutyloxethyl)-1,3,5-triazine-2,4,6(1H,3H,5H)-trione

## Example 12

The resins shown in Table 16 were prepared as described above. Depth of cure (DOC) was measured in the method described above.

**TABLE 17**

| RESIN | COMPONENTS (%) | | | | ADDITIVE (phr) | DOC (sec) |
|---|---|---|---|---|---|---|
| | IBOA | TMPTA | CN9004 | PEGDA | PE1 | |
| H5 | 69 | 1 | 30 | | 5 | 7-8 |
| H9 | 69 | | 30 | 1 | 5 | 8 |
| IBOA: Sigma Aldrich; Isobornyl acrylate<br>TMPTA: Sigma Aldrich; Trimethylolpropane triacrylate<br>CN9004: Sartomer; aliphatic urethane acrylate<br>PEGDA: Sigma Aldrich; Poly(ethylene glycol) diacrylate<br>PE1: Showa Denko; Pentaerythritol tetrakis (3-mercaptobutylate) | | | | | | |

**Example 13**

The resins shown in Table 18 were prepared as described above.

**TABLE 18**

| RESIN | COMPONENTS (%) | | | | | | | | | | | ADDITIVES (phr) | | | |
|---|---|---|---|---|---|---|---|---|---|---|---|---|---|---|---|
| | EA | EHA | HPA | SR531 | PEGDA | PBD | CN9782 | CN9167 | CN9004 | IBOA | BA | PE1 | BD1 | ACR | Silica |
| D1.1 | | | | | | | | | 48 | 48 | | 5 | | 1 | |
| D2 | | | | | | | | | 10 | | 83 | 5 | | 2 | |
| D2.2 | | | | | | | | | 20 | | 73 | 5 | | 2 | |
| D2.6 | | | | | | | | | 47 | | 47 | 5 | | 2 | |
| D4.0 | | | | | | 95 | | | | | | 5 | | | |
| D4.1 | | | | | | 90 | | | | | | 10 | | | |
| D5.5 | | | | 55 | | | | | 35 | | | 5 | | 5 | |
| D5.6 | | | | 30 | | | | 70 | | | | 5 | | | |
| D5.7 | | | | 80 | | | | | 20 | | | 5 | | 2 | |
| D5.8 | | | | 70 | | | | 10 | 20 | | | 5 | | | |
| D5.9 | | | | 70 | | | | 15 | 15 | | | 5 | | | |
| D6.0 | | | | 68 | | | | | 32 | | | 5 | | 2 | 2 |
| D6.1 | | | | 68 | | | | | 32 | | | 5 | | 2 | 10 |
| D6.3 | | | 20 | 50 | | | | | 30 | | | 5 | | 2 | 5 |
| D6.4 | | | | 68 | | | | | 32 | | | 5 | | 2 | 3 |
| D6.5 | | | | 68 | | | | | 32 | | | 5 | | 2 | 6 |
| D7.0 | | 70 | | | | | | | 30 | | | 5 | | 2 | |
| D7.2 | | 50 | | | | | | | 40 | | | 5 | | 5 | |
| D8.2.1 | | | 35 | 35 | | | | | 30 | | | 5 | | 2 | 5 |
| D8.3 | | | 80 | | | | | | 20 | | | 5 | | 5 | 5 |
| D8.5 | | 30 | 20 | 20 | | | | | 30 | | | 5 | | 2 | |
| D10.0 | | | | | | | | 100 | | | | 5 | | | |
| D11.0NT | | | | 55 | | | | 30 | | 15 | | 0 | | | |
| D11.0NT.1 | | | | 55 | | | | 30 | | 15 | | 0 | | | 5 |

(continued)

| RESIN | COMPONENTS (%) | | | | | | | | | | | ADDITIVES (phr) | | | |
|---|---|---|---|---|---|---|---|---|---|---|---|---|---|---|---|
| | EA | EHA | HPA | SR531 | PEGDA | PBD | CN9782 | CN9167 | CN9004 | IBOA | BA | PE1 | BD1 | ACR | Silica |
| D12.0 | | | | | | | | 75 | 25 | | | 5 | | | |
| D12.0NT | | | | | | | | 75 | 25 | | | 0 | | | |
| D12.1NT | | | | | | | | 72.5 | 22.5 | 5.0 | | 0 | | | |
| D12.2 | | | | | | | | 75 | 25.0 | | | | | 10 | | |
| D12.3 | | | | | | | | 70 | 25.0 | 5.0 | | | | 20 | | |
| D13.0 | | 40 | | | | | | 60 | | | | 5 | | | |
| D13.0NT | | 40 | | | | | | 60 | | | | 0 | | | |
| D14.0 | | 25 | | | | | | 75 | | | | 5 | | | |
| HP 1 | 10 | 15 | | 12 | 10 | | 10 | 15 | 8 | 10 | 10 | | | 2 | |
| HP 2 | 10 | 10 | | 20 | | | 10 | 12 | 8 | 20 | 10 | | | 2 | |
| HP4 | | | | 70 | | | 10 | 10 | 10 | | | | | 2 | |
| HP5 | | 30 | | 30 | | | | 30 | | 5 | 5 | | | 2 | |
| HP6 | | 15 | | 45 | | | | 20 | | 15 | 5 | | | 2 | |
| D5.? | | | | 60 | | | | | 30 | 10 | | 5 | | | |
| D5.?2 | | | 47 | | | | | | 30 | 23 | | 5 | | | |
| D11.? | | | | 60 | | | | | 30 | | 10 | 5 | | | |

(continued)

| RESIN | COMPONENTS (%) | | | | | | | | | | | ADDITIVES (phr) | | | |
|---|---|---|---|---|---|---|---|---|---|---|---|---|---|---|---|
| | EA | EHA | HPA | SR531 | PEGDA | PBD | CN9782 | CN9167 | CN9004 | IBOA | BA | PE1 | BD1 | ACR | Silica |
| D11Q2 | | | | 49 | | | | | 30 | 21 | | 5 | | | |

EA: Ethyl acrylate
EHA: Sigma Aldrich; Ethylhexyl acrylate
HPA: Sigma Aldrich; Hydroxypropyl acrylate
SR531: Sartomer; Cyclic trimethylolpropane formal acrylate
PEGDA: Sigma Aldrich; Poly(ethylene glycol) diacrylate
PBD = Sigma Aldrich; Polybutadiene, 1,2 addition 90%
CB9028: Sartomer; aliphatic urethane acrylate
CN9167: Sartomer; aromatic urethane acrylate
CN9004: Sartomer; aliphatic urethane acrylate
IBOA: Sigma Aldrich; Isobornyl acrylate
BA: Sigma Aldrich; Butyl acrylate
PE1: Showa Denko; Pentaerythritol tetrakis (3-mercaptobutylate)
BD1: Showa Denko; 1,4-bis (3-mercaptobutylyloxy) butane
ACR: Siltech; Polydimethylsiloxane Acrylate Copolymer
Silica: Aerosil R 972

**Example 14**

The resins shown in Table 19 were prepared as described above.

**TABLE 19**

| RESIN | COMPONENTS (%) | | | | | ADDITIVES (phr) | | | |
|---|---|---|---|---|---|---|---|---|---|
| | HPA | SR531 | CN9167 | CN9004 | IBOA | PE1 | BD1 | NR1 | ACR |
| Strat PJ Riqid F3 | 60 | | 40 | | | 5 | | | |
| Strat PJ Rigid | | 55 | 30 | | 15 | 5 | 5 | | |
| Strat PJ Flexible | 70 | | | 30 | | 2.5 | 7.5 | | 2 |
| Strat PJ Flexible T | 33.3 | | | | | 10 | | | 66.7 |
| Strat PJ Flexible 8.0 | 70 | | | 30 | | 5 | | | 2 |
| Strat PJ Flexible 8.1 | 70 | | | 30 | | 10 | | | 2 |
| Strat PJ Flexible 8.2 | 70 | | | 30 | | 15 | | | 2 |
| F17 | 70 | | 30 | | | 10 | | | |
| F20 | 70 | | 30 | | | | | 10 | |
| F24 | 40 | | 30 | | 30 | 15 | | | |
| F25 | 30 | | 30 | | 40 | 15 | | | |

HPA: Sigma Aldrich; Hydroxypropyl acrylate
SR531: Sartomer; Cyclic trimethylolpropane formal acrylate
CN9167: Sartomer; aromatic urethane acrylate
CN9004: Sartomer; aliphatic urethane acrylate
IBOA: Sigma Aldrich; Isobornyl acrylate
PE1: Showa Denko; Pentaerythritol tetrakis (3-mercaptobutylate)
BD1: Showa Denko; 1,4-bis (3-mercaptobutylyloxy) butane
NR1: Showa Denko; 1,3,5-Tris(3-melcaptobutyioxethyl)-1,3,5-triazine-2,4,6(1H,3H,5H)-trione
ACR: Siltech; Polydimethylsiloxane Acrylate Copolymer

**Example 15**

The resins shown in Table 20 were prepared as described above.

**TABLE 20**

| RESIN | COMPONENTS (%) | | | | | | | ADDITIVES (phr) | | |
|---|---|---|---|---|---|---|---|---|---|---|
| | HPA | CN9004 | IBOA | TMPTA | PEGDA | TCDMDA | Bisacrylamide | PE1 | BD1 | NR1 |
| H1 | | 30 | 70 | | | | | 5 | | |
| | HPA | CN9004 | IBOA | TMPTA | PEGDA | TCDMDA | Bisacrylamide | PE1 | BD1 | NR1 |
| H3 | 10 | 30 | 60 | | | | | 5 | | |
| H4 | 20 | 30 | 50 | | | | | 5 | | |
| H15 | | 30 | 65 | | | | 5 | 5 | | |
| H16 | | 30 | 60 | | | | 10 | 5 | | |
| H17 | | 30 | 50 | 20 | | | | 5 | | |
| H18 | | 20 | 75 | 5 | | | | 5 | | |
| H19 | | 20 | 70 | 10 | | | | 5 | | |
| H20 | | 20 | 60 | 20 | | | | 5 | | |

(continued)

| | HPA | CN9004 | IBOA | TMPTA | PEGDA | TCDMDA | Bisacrylamide | PE1 | BD1 | NR1 |
|---|---|---|---|---|---|---|---|---|---|---|
| H21 | | 10 | 85 | 5 | | | | 5 | | |
| H22 | | 10 | 80 | 10 | | | | 5 | | |
| H23 | | 10 | 70 | 20 | | | | 5 | | |
| H24 | | 30 | 55 | 15 | | | | 5 | | |
| H25 | | 30 | 68 | 2 | | | | | 5 | |
| H26 | | 30 | 68 | 2 | | | | | | 5 |
| H27 | | 30 | 50 | 20 | | | | | 5 | 5 |
| H28 | | 30 | 50 | | 20 | | | 1 | 2 | 3 |
| H29 | | 30 | 50 | | | 20 | | 2 | 3 | 2 |
| H30 | | 30 | 50 | 10 | 10 | | | 3 | 4 | 1 |
| H31 | | 30 | 50 | 10 | | 10 | | 5 | 1 | |
| H32 | | 30 | 50 | | 10 | 10 | | 1 | 2 | 3 |
| H33 | | 30 | 50 | 10 | 5 | 5 | | 2 | 3 | 2 |
| H34 | | 30 | 50 | 5 | 10 | 5 | | 3 | 4 | 1 |
| H35 | | 30 | 50 | 5 | 5 | 10 | | 5 | 1 | |
| H36 | | 30 | 55 | 10 | 5 | | | | 5 | 5 |
| H37 | | 30 | 55 | 10 | | 5 | | 2 | 3 | 2 |
| H38 | | 30 | 55 | 5 | 10 | | | 3 | 4 | 1 |
| H39 | | 30 | 55 | 5 | | 10 | | 5 | 1 | |
| H40 | | 30 | 55 | | 10 | 5 | | | 5 | 5 |
| H41 | | 30 | 55 | | 5 | 10 | | 1 | 3 | 3 |
| H42 | | 30 | 55 | 5 | 5 | 5 | | 3 | 4 | 1 |
| H43 | | 30 | 60 | 10 | | | | 5 | 1 | |
| H44 | | 30 | 60 | | 10 | | | | 5 | 5 |
| H45 | | 30 | 60 | | | 10 | | 1 | 2 | 3 |
| H46 | | 30 | 60 | 5 | 5 | | | 2 | 4 | 2 |
| H47 | | 30 | 60 | 5 | | 5 | | 5 | 1 | |
| H48 | | 30 | 60 | | 5 | 5 | | | 5 | 5 |
| H49 | | 30 | 65 | 5 | | | | 1 | 2 | 3 |
| H50 | | 30 | 65 | | 5 | | | 2 | 3 | 2 |
| H51 | | 30 | 65 | | | 5 | | 3 | 3 | 1 |

HPA: Sigma Aldrich; Hydroxypropyl acrylate
CN9004: Sartomer; aliphatic urethane acrylate
IBOA: Sigma Aldrich; Isobornyl acrylate
TMPTA: Sigma Aldrich; Trimethylolpropane triacrylate
PEGDA: Sigma Aldrich; Poly(ethylene glycol) diacrylate
TCDMDA: Sigma Aldrich; Tricyclo[5.2.1.0$^{2,6}$]decanedimethanol diacrylate
Bisacrylamide: Sigma Aldrich; N,N'-Methylenebis(acrylamide)
PE1: Showa Denko; Pentaerythritol tetrakis (3-mercaptobutylate)
BD1: Showa Denko; 1,4-bis (3-mercaptobutylyloxy) butane

**Example 16**

The resins shown in Table 21 were prepared as described above.

TABLE 21

| RESIN | COMPONENTS (%) | | | | | | ADDITIVES (phr) | | | | | | |
|---|---|---|---|---|---|---|---|---|---|---|---|---|---|
| | HBA | IBOA | SR531 | CN9004 | CN9028 | TMPTA | PE1 | NR1 | TPO | BBOT | CB | BHT | OX50 |
| B021501 | 40 | 30 | | 30 | | 1 | 5 | | 1 | | 0.03 | 0.1 | |
| B021502 | 40 | 30 | | 30 | | 0.5 | 5 | | 1 | | 0.03 | 0.1 | |
| B021503 | 40 | 30 | | 30 | | 0.1 | 5 | | 1 | | 0.03 | 0.1 | |
| B020711 | 40 | 30 | | 30 | | 1 | 5 | | 2 | | 0.03 | 0.2 | |
| B020712 | 40 | 30 | | 30 | | 1 | 5 | | 1 | | 0.03 | 0.1 | |
| B020713 | 40 | 30 | | 30 | | 1 | 5 | | 1 | | 0.03 | 0.05 | |
| 8020714 | 40 | 30 | | 30 | | 1 | 5 | | 1 | | 0.03 | 0.025 | |
| B011403 | 70 | | | | 30 | 1 | | | | | | | 30 |
| A122001 | 70 | | | 30 | | | 5 | | 0.5 | | | | |
| A122002 | | | 70 | 30 | | | 5 | | 0.5 | | | | |
| A 121801 | 50 | | 20 | 30 | | | 5 | | 0.5 | | | | |
| A 121701 | 70 | | | | 30 | 0.5 | 5 | | 0.5 | | | | 32 |
| A121702 | 70 | | | | 30 | 0.5 | 5 | | 0.5 | | | | 34 |
| A121703 | 70 | | | | 30 | 0.5 | 5 | | 0.5 | | | | 36 |
| A121704 | 70 | | | | 30 | 0.5 | 5 | | 0.5 | | | | 38 |
| A121705 | 70 | | | | 30 | 0.5 | 5 | | 0.5 | | | | 40 |
| A 121401 | 80 | | | | 20 | | | 5 | | | | | 20 |
| A121402 | 80 | | | | 20 | | | 5 | | | | | 30 |
| A121403 | 70 | | | | 30 | | | 5 | | | | | 20 |
| A121404 | 70 | | | | 30 | | | 5 | | | | | 30 |
| A120301 | | 68 | | 30 | | 2 | 5 | | 0.5 | | | 0 | |
| A120302 | | 68 | | 30 | | 2 | 5 | | 0.5 | | | 0.05 | |
| A120303 | | 68 | | 30 | | 2 | 5 | | 0.5 | | | 0.25 | |
| A120304 | | 68 | | 30 | | 2 | 1 | | 0.5 | | | 0 | |

EP 3 896 519 A1

(continued)

| RESIN | COMPONENTS (%) | | | | | | ADDITIVES (phr) | | | | | | |
|---|---|---|---|---|---|---|---|---|---|---|---|---|---|
| | HBA | IBOA | SR531 | CN9004 | CN9028 | TMPTA | PE1 | NR1 | TPO | BBOT | CB | BHT | OX50 |
| A120305 | | 68 | | 30 | | 2 | 1 | | 0.5 | | | 0.05 | |
| A120306 | | 68 | | 30 | | 2 | 1 | | 0.5 | | | 0.25 | |
| A120307 | | 68 | | 30 | | 2 | 0.5 | | 0.5 | | | 0 | |
| A120308 | | 68 | | 30 | | 2 | 0.5 | | 0.5 | | | 0.05 | |
| A120309 | | 68 | | 30 | | 2 | 0.5 | | 0.5 | | | 0.25 | |
| B022201 | 1 | 68 | | 30 | | 1 | 5 | | 1 | 0.025 | | 0.1 | |
| 8022202 | 0.5 | 68 | | 30 | | 1.5 | 5 | | 1 | 0.025 | | 0.1 | |
| B021211 | | 68 | | 30 | | 2 | 5 | | 1 | 0.025 | | 0.1 | |
| B021212 | | 68 | | 30 | | 2 | 5 | | 1 | 0.025 | | 0.05 | |
| B8021213 | | 68 | | 30 | | 2 | 5 | | 1 | 0.025 | | 0.025 | |
| B020401 | | 68 | | 30 | | 2 | 5 | | 0.5 | 0.025 | | 0.05 | |
| 8020402 | | 68 | | 30 | | 2 | 5 | | 1 | 0.025 | | 0.1 | |
| B020403 | | 68 | | 30 | | 2 | 5 | | 1.5 | 0.025 | | 0.15 | |
| B020404 | | 68 | | 30 | | 2 | 5 | | 2 | 0.025 | | 0.2 | |
| B020101 | | 68 | | 30 | | 2 | 5 | | 2 | | 0.03 | 0.2 | |

HPA: Sigma Aldrich; Hydroxypropyl acrylate
IBOA: Sigma Aldrich; Isobornyl acrylate
SR531: Sartomer; Cyclic trimethylolpropane formal acrylate
CN9004: Sartomer; aliphatic urethane acrylate
CB9028: Sartomer; aliphatic urethane acrylate
TMPTA: Sigma Aldrich; Trimethylolpropane triacrylate
PE1: Showa Denko; Pentaerythritol tetrakis (3-mercaptobutylate)
NR1: Showa Denko; 1,3,5-Tris(3-melcaptobutyloxethyl)-1,3,5-triazine-2,4,6(1H,3H,5H)-trione
TPO: Sigma Aldrich; Diphenyl(2,4,6-trimethylbenzoyl)phosphine oxide
BBOT: Sigma Aldrich; 2,5-Bis(5-tert-butyl-benzoxazol-2-yl)thiophene
CB: Carbon Black
BHT: Butylated hydroxytoluene (inhibitor)
OX50: Evonik; OH-functional Silica

**Example 17**

The resins shown in Table 22 were prepared as described above.

## TABLE 22

| RESIN | COMPONENTS (%) | | | | | | | | | | | | | ADDITIVES (phr) | |
|---|---|---|---|---|---|---|---|---|---|---|---|---|---|---|---|
| | PEG | DMAAm | AAm | P(S-MA) | NIPAM | EHA | HPA | SR531 | PEGDA | CN9167 | CN9004 | IBOA | BA | PE1 | BD1 |
| 1690 | | | | | 10 | | 60 | | | | 30 | | | 5 | |
| 1691 | | | | | 15 | | 55 | | | | 30 | | | 5 | |
| 1750 | | | | 5 | 5 | | 70 | | | | 20 | | | | 5 |
| 1751 | | | | | 10 | | 70 | | | | 20 | | | | 5 |
| 1790 (1690) | | | | | 10 | | 60 | | | | 30 | | | | 5 |
| 1791 | | | | | 20 | | 50 | | | | 30 | | | | 5 |
| 1792 | | | | | 30 | | 40 | | | | 30 | | | | 5 |
| 1793 | | | 10 | | | | | 60 | | | 30 | | | | 5 |
| 1812 | | | 5 | | | 45 | | 20 | | | 30 | | | 5 | |
| 1813 | | | 10 | | | 40 | | 20 | | | 30 | | | 5 | |
| 1850 | | | | | | | | | | 100 | | | | | 5 |
| 1851 | 10 | | | | | | | | | 90 | | | | | 5 |
| 1852 | 20 | | | | | | | | | 80 | | | | | |
| 1853 | 50 | | | | | | | | | 50 | | | | | |
| **1870** | | | 10 | | | | | 60 | | | 30 | | | | 5 |
| **1871** | | | 10 | | | | 60 | | | | 30 | | | | 5 |
| 1872 (1690) | | | | | 10 | | 60 | | | | 30 | | | | 5 |
| 1890 | | | 5 | | | | 75 | | | | 20 | | | | 5 |
| 1891 | | | 20 | | | | 60 | | | | 20 | | | | 5 |
| 1910 | | | | 7 | | | | | | | 30 | | | 5 | |
| 1911 | | | | 10 | | | 60 | | | | 30 | | | 5 | |
| 1912 | | | | 10 | | | 90 | | | | | | | 5 | |
| 1913 (1910) | | | | 7 | | | 63 | | | | 30 | | | 5 | |
| 1930 | | | 20 | | | | | 60 | | | 20 | | | | 5 |

| RESIN | COMPONENTS (%) | | | | | | | | | | | | | ADDITIVES (phr) | |
|---|---|---|---|---|---|---|---|---|---|---|---|---|---|---|---|
| | PEG | DMAAm | AAm | P(S-MA) | NIPAM | EHA | HPA | SR531 | PEGDA | CN9167 | CN9004 | IBOA | BA | PE1 | BD1 |
| 1931 | | | 30 | | | | | 40 | | | 20 | | | | 5 |
| 1932 | | 5 | 5 | | | 60 | | | | | 30 | | | 5 | |
| 1933 | | 10 | 10 | | | 50 | | | | | 30 | | | 5 | |
| 1951(1871) | | | 10 | | | | 60 | | | | 30 | | | | 5 |
| 1952 | | | 20 | | | | 50 | | | | 30 | | | | |
| 1970 | | 15 | 15 | | | | | 40 | | | 30 | | | | 5 |
| 1971 | | 70 | | | | | | | | | 30 | | | | 5 |
| 1972 | | 30 | 30 | | | 10 | | | | 30 | | | | | 5 |
| 1990 | | | 10 | | | 10 | 50 | | | | 30 | | | | 5 |
| 1991 | | 70 | | | | | | | | | 30 | | | | 5 |
| 11010 | | | | 2 | | 14 | 41 | | | | 43 | | | | 5 |
| 11011 | | | | 4 | | 14 | 39 | | | | 43 | | | | 5 |
| 11012 | | | | 9 | | 14 | 34 | | | | 43 | | | | 5 |
| 11030 | | 50 | | | | 20 | 70 | | 10 | | | | | | |
| 11031 | | 50 | | | | 20 | 60 | | 20 | | | | | | |
| 11032 | | 50 | | | | 20 | 30 | | 30 | | | | | | |
| 11050 | | | | | | | | | | | 40 | 36 | 24 | 5 | |
| 11051 | | | | 12 | | 10 | 48 | | | | 30 | | | 5 | |
| 11052(1870) | | | 10 | | | | | 60 | | | 30 | | | | 5 |

EP 3 896 519 A1

(continued)

| RESIN | COMPONENTS (%) | | | | | | | | | | | | | ADDITIVES (phr) | |
|---|---|---|---|---|---|---|---|---|---|---|---|---|---|---|---|
| | PEG | DMAAm | AAm | P(S-MA) | NIPAM | EHA | HPA | SR531 | PEGDA | CN9167 | CN9004 | IBOA | BA | PE1 | BD1 |
| 11053 (1951) | | | 10 | | | | 60 | | | | 30 | | | | 5 |

PEG: Sigma Aldrich; Polethylene glycol DMA Am: Sigma Aldrich; N,N'-Dimethylacrylamide AAm: Sigma Aldrich; Acrylamide P(S-MA): Sigma Aldrich; copolymer poly(styrene-co-maleic anhydride) NIPAM: Sigma Aldrich; N-isopropylacrylamide EHA: Sigma Aldrich; Ethylhexyl acrylate HPA: Sigma Aldrich; Hydroxypropyl acrylate SR531: Sartomer; Cyclic trimethylolpropane formal acrylate PEGDA: Sigma Aldrich; Poly(ethylene glycol) diacrylate CN9167: Sartomer; aromatic urethane acrylate CN9004: Sartomer; aliphatic urethane acrylate IBOA: Sigma Aldrich; Isobornyl acrylate BA: Sigma Aldrich; Butyl acrylate PE1: Showa Denko; Pentaerythritol tetrakis (3-mercaptobutylate) BD1: Showa Denko; 1,4-bis (3-mercaptobutylyloxy) butane

Each of the resins was photocured to form a cast sample for testing. The hardness was measured. Further, the mechanical properties were measured using uniaxial tensile testing. The results obtained are given in Table 23.

TABLE 23

| RESIN | DOC (S) | Hardness (Shore A) | Toughness (MJ/m$^3$) | Ult.Tensile (Mpa) |
|---|---|---|---|---|
| 1851 | | | 1.5 | 32.8 |
| 1852 | | | 1.76 | 12.16 |
| 1853 | | | | |
| 1870 | | | 29.57 | 16.37 |
| 1972 | <2 | >90 | | |
| 1990 | 5 | >90 | | |
| 1991 | 25-60 | >90 | | |
| 11030 | 65 | | | |
| 11031 | 7-15 | | | |
| 11032 | 15-20 | | | |
| 11050 | 20 | | | |
| 11051 | 6-15 | | | |
| 11052(1870) | 5 | | | |
| 11053(1951) | 5 | | | |

## Claims

1. A photopolymerizable resin for additive manufacturing, the resin comprising:

   about 5-15 phr of a thiol;
   about 20-60% of a difunctional acrylic oligomer; and
   about 40-80% of one or more monofunctional acrylic monomers;
   wherein the resin is configured to react by exposure to light to form a cured material.

2. The photopolymerizable resin according to claim 1, wherein the thiol includes a secondary thiol.

3. The photopolymerizable resin according to claim 2, wherein the secondary thiol includes at least one of Pentaerythritol tetrakis (3-mercaptobutylate); 1,4-bis (3-mercaptobutylyloxy) butane; and/or 1,3,5-Tris(3-melcaptobutyloxethyl)-1,3,5-triazine-2,4,6(1H,3H,5H)-trione.

4. The photopolymerizable resin according to claim 1, wherein the difunctional acrylic oligomer includes a urethane acrylate oligomer.

5. The photopolymerizable resin according to claim 1, wherein the difunctional acrylic oligomer includes an aliphatic urethane acrylate oligomer.

6. The photopolymerizable resin according to claim 1, wherein the difunctional acrylic oligomer includes an aromatic urethane acrylate oligomer.

7. The photopolymerizable resin according to claim 1, wherein the difunctional acrylic oligomer includes at least one of CN9782, CN9167, and/or CN9004.

8. The photopolymerizable resin according to claim 1, wherein the monofunctional acrylic monomer has a molecular weight less than 200.

9. The photopolymerizable resin according to claim 1, wherein the monofunctional acrylic monomer includes at least one of 2-ethylhexyl acrylate, hydroxypropyl acrylate, butyl acrylate, and/or 2-hydroxyethyl methacrylate.

FIG. 1

**Toughness**: 9.58 MJ/m$^3$
**Onset of T$_g$**: 20 °C
**Use Range**: 15 to 40 °C
**Strain**: 66.1 %
**Stress**: 17.93 MPa
**Durometer**: 96 Shore A
**Viscosity**: 58 cP (20 °C)
**DOC**: 2.25 s

FIG 2.

FIG. 3

FIG. 4

EP 3 896 519 A1

Europäisches
Patentamt

European
Patent Office

Office européen
des brevets

## EUROPEAN SEARCH REPORT

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2018/010490 A1 (ZHUHAI SEINE TECH CO LTD [CN]) 18 January 2018 (2018-01-18) * embodiments 1-5; page 2, line 34 - page 3, line 3; claims 1-9; tables 1, 3 * | 1,4,5,8 | INV. G03F7/00 G03F7/027 B33Y70/00 |
| X | EP 2 781 535 A1 (THREE BOND FINE CHEMICAL CO LTD [JP]) 24 September 2014 (2014-09-24) * examples 1-8, comp. examples 1,4, 5, 10 and 11; claim 1 * | 1,4,5,8 | |
| A | WO 2012/126695 A1 (HUNTSMAN ADV MAT SWITZERLAND [CH]; CHERKAOUI ZUBAIR [CH] ET AL.) 27 September 2012 (2012-09-27) * claims 1-15; examples 1-32; table IIA to IIF * | 1-9 | |
| A | WO 2017/051182 A1 (PHOTOCENTRIC LTD [GB]) 30 March 2017 (2017-03-30) * experimental part; page 1, lines 5-29; claims 1-31 * | 1-9 | TECHNICAL FIELDS SEARCHED (IPC) G03F B33Y |
| A | US 2010/140850 A1 (NAPADENSKY EDUARDO [IL] ET AL) 10 June 2010 (2010-06-10) * the whole document * | 1-9 | |

The present search report has been drawn up for all claims

| Place of search | Date of completion of the search | Examiner |
|---|---|---|
| Munich | 7 September 2021 | Eggers, Karin |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 20 21 1692

This annex lists the patent family members relating to the patent documents cited in the above-mentioned European search report.
The members are as contained in the European Patent Office EDP file on
The European Patent Office is in no way liable for these particulars which are merely given for the purpose of information.

07-09-2021

| Patent document cited in search report | | Publication date | Patent family member(s) | | Publication date |
|---|---|---|---|---|---|
| WO 2018010490 | A1 | 18-01-2018 | CN 107459871 A | | 12-12-2017 |
| | | | US 2018312707 A1 | | 01-11-2018 |
| | | | WO 2018010490 A1 | | 18-01-2018 |
| EP 2781535 | A1 | 24-09-2014 | CN 103946274 A | | 23-07-2014 |
| | | | EP 2781535 A1 | | 24-09-2014 |
| | | | JP 6112014 B2 | | 12-04-2017 |
| | | | JP WO2013073364 A1 | | 02-04-2015 |
| | | | KR 20140089549 A | | 15-07-2014 |
| | | | US 2014309327 A1 | | 16-10-2014 |
| | | | WO 2013073364 A1 | | 23-05-2013 |
| WO 2012126695 | A1 | 27-09-2012 | NONE | | |
| WO 2017051182 | A1 | 30-03-2017 | EP 3353604 A1 | | 01-08-2018 |
| | | | US 2018282544 A1 | | 04-10-2018 |
| | | | WO 2017051182 A1 | | 30-03-2017 |
| US 2010140850 | A1 | 10-06-2010 | NONE | | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 62649130

- US 62660894